# EUROPEAN PATENT APPLICATION

(11) **EP 1 809 077 A2**
(43) Date of publication of application: **18.07.2007**
(21) Application number: 05785858.1
(22) Date of filing: 22.09.2005
(51) Int. Cl.: H05B 33/14, C09K 11/06

(54) **ORGANIC ELECTROLUMINESCENT ELEMENT**

(30) Priority: 22.09.2004 JP 2004276010
(71) Applicant: Japan Science and Technology Agency, Kawaguchi-shi, Saitama 332-0012 (JP); National University Corporation Hokkaido University, Sapporo-shi, Hokkaido 060-0808 (JP)
(72) Inventor: ENDO, Ayataka, c/o DEPT. PHOTONICS MATERIALS SCI., Chitose-shi, Hokkaido 066-8655 (JP); ADACHI, Chihaya, c/o Center for Future Chemistry, Nishi-ku, Fukuoka-shi, Fukuoka 8190395 (JP); TSUJI, Yasushi, c/o CATALYSIS RESEARCH CENTER, Hokkaido 001-0021 (JP); TOKUNAGA, Makoto, c/o CATALYSIS RESEARCH CENTER, Hokkaido 001-0021 (JP); OBORA, Yasushi, c/o CATALYSIS RESEARCH CENTER, Hokkaido 001-0021 (JP); IWASAWA, Tetsuo, c/o CATALYSIS RESEARCH CENTER, Hokkaido 001-0021 (JP)
(74) Representative: Steil, Christian
(86) International application number: PCT/JP2005/017531
(87) International publication number: WO 2006/040915

(57) **Abstract**

Disclosed is an organic EL device comprising an electroluminescent layer having a single layer or a multilayered structure of two or more layers, the electroluminescent layer containing a pyridine derivative represented by the formula (1): 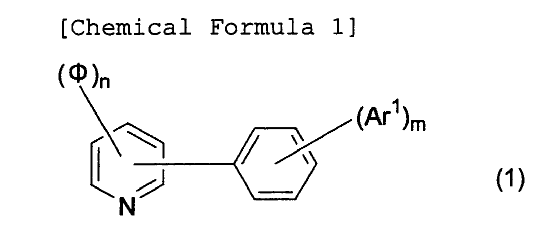 wherein Ar¹ represents an aryl group, m represents an integer of 1 to 5, Φ represents a group represented by the formula (1a) : 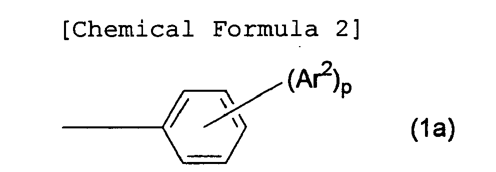 (wherein Ar² represents an aryl group, and p represents an integer of 1 to 5),
or the formula (1b): 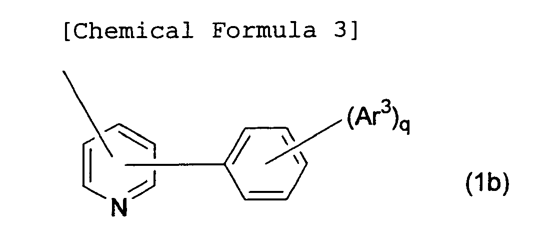 (wherein Ar³ represents an aryl group, and q represents an integer of 1 to 5), and n represents an integer of 0 to 2. The organic EL device is excellent in luminescent efficiency, luminance and durability, and emits blue light with improved luminescent efficiency and luminance, which are the same as those of other colors, and is also is excellent in durability.

## Description

### BACKGROUND OF THE INVENTION

### Field of the Invention

The present invention relates to an organic electroluminescent device.

### Description of Related Art

Intense interest has been shown towards a thin film type organic electroluminescent device (hereinafter abbreviated to an "organic EL device", sometimes) as a next-generation technique, because it has various merits, for example, not only the organic electroluminescent device enables to produce a display device, which is thinner than a liquid crystal display requiring a backlight because of its self-luminous type, but also enables to produce a thin liquid crystal display using a backlight which is thinner than a conventional one, and also has more simple structure than that of the plasma display.

At first, as an organic EL device, an device having a structure wherein a single crystal or vapor deposited film made of an organic fluorescent material such as anthracene is interposed between a cathode and an anode was studied. Subsequently, there have been widely studied about organic EL devices comprising a function separation type electroluminescent layer consisting of a single layer or having a multilayered structure composed of two or more layers formed using compounds each having an excellent function, for example, luminescent material having phosphorescence or fluorescence, electron transporting material having electron transportability, hole transporting material having hole transportability, and binder having film forming properties, in combination so as to enhance luminescent efficiency of an device by improving recombination efficiency of electrons and holes.

For example, C. W. Tang and S. A. VanSlyke; Appl. Phys. Lett., 51 (1987) 913 proposes an organic EL device comprising a two-layered structure electroluminescent layer composed of an electron transporting layer containing an electron transporting material and a hole transporting layer containing a hole transporting material which are laminated with each other, the electron transporting layer being provided with a function to be used for a luminescent layer. The device has the following constitution: cathode/electron transporting layer/hole transporting layer/anode/substrate.

In this organic EL device, the hole transporting layer has a function of injecting holes injected from an anode to an electron transporting layer, and also has a function of preventing electrons injected from a cathode to the electron transporting layer from escaping to the anode without recombining with holes, and enclosing in the electron transporting layer. Therefore, the electrons and the holes can be efficiently recombined in the electron transporting layer. Further, it is possible to enable an electron transporting material contained in the electron transporting layer to efficiently emit light, thereby improving luminescent efficiency of an organic EL device and decreasing the drive voltage.

Further, C. Adachi, T. Tsutsui and S. Saito; Appl. Phys. Lett., 55(1989) 1489 discloses that a hole transporting layer can also serve as a luminescent layer in the electroluminescent layer having a two-layered structure. Similarly, the device has the following constitution: cathode/electron transporting layer/hole transporting layer/anode/substrate.

In this organic EL device, the electron transporting layer has a function of injecting electrons injected from a cathode to the hole transporting layer and also has a function of preventing holes injected from an anode to the hole transporting layer from escaping to the cathode without recombining with electrons, and enclosing in the hole transporting layer. Therefore, the electrons and the holes can be efficiently recombined in the hole transporting layer. Further, it is possible to enable a hole transporting material contained in the hole transporting layer to efficiently emit light, thereby improving luminescent efficiency of an organic EL device and decreasing the drive voltage.

Furthermore, C. Adachi, S. Tokito, T. Tsutsui and S. Saito; Jpn. J. Appl. Phys., 27 (1988) L269 proposes an organic EL device comprising an electroluminescent layer having a three-layered structure wherein a luminescent layer containing a luminescent material is interposed between an electron transporting layer and a hole transporting layer. The device has the following constitution: cathode/electron transporting layer/luminescent layer/hole transporting layer/anode/substrate.

In this organic EL device, the hole transporting layer has a function of injecting holes injected from an anode to a luminescent layer, and also has a function of preventing electrons injected from a cathode to the luminescent layer from escaping to the anode without recombining with holes, and enclosing in the luminescent layer. Further, the electron transporting layer has a function of injecting electrons injected from a cathode to the luminescent layer and also has a function of preventing holes injected from an anode to the luminescent layer from escaping to the cathode without recombining with electrons, and enclosing in the luminescent layer. Therefore, as compared with those having a two-layered structure, it is possible to further improve recombination efficiency of electrons and holes in the luminescent layer, thereby further improving luminescent efficiency of an organic EL device and to further decreasing the drive voltage.

In these organic EL devices, oxadiazoles and triazoles are used as the electron transporting material, and aromatic tertiary amines such as triphenylamine derivative are commonly used as the hole transporting material, respectively. Further, an organic metal complex or an organic metal compound, each having phosphorescence or fluorescence, are used as the luminescent material.

Since the phosphorescent luminescent material is commonly inferior in film forming properties and is also likely to cause self-quenching in an excitation state, luminescent efficiency of the organic EL device tends to decrease. In order to improve luminescent efficiency by preventing a decrease in luminescent efficiency, for example, a phenylcarbazole derivative is used as a host material and a phosphorescent luminescent material as a guest material is dispersed in the host material to form a luminescent layer.

Furtehr, Japanese Patent Publication No. JP7-285937A, Japanese Patent Publication No. JP2001-97950A, Japanese Patent Publication No. JP2003-17268A and Japanese Patent Publication No. JP2005-26221A respectively describe that a pyridine derivative containing pyridine as a basic skeleton is useful as an electron transporting material of an organic EL device.

### Summary of the Invention

In order to produce a novel display device to be replaced by a liquid crystal display using an organic EL device, microluminescent cells with a constitution of an organic EL device capable of emitting lights of three primary colors, such as red, green and blue lights, are arranged every dot of a display. To realize this fact, it is essential that organic EL devices constituting luminescent cells of red, green and blue colors emit light with almost the same luminescent efficiency and luminance.

However, with respect to green and red colors, a luminescent material and a luminescent layer that can constitute an device having high luminescent efficiency and luminance required to realize the above display device have already been put into practical use. However, the blue color having the same luminescent efficiency and luminance as those in case of green and red colors has not been developed yet.

For example, quantum efficiency of an organic EL device comprising a luminescent layer having such a structure that 4, 4'-di(N-carbazolyl)biphenyl <CBP> represented by the formula (51): 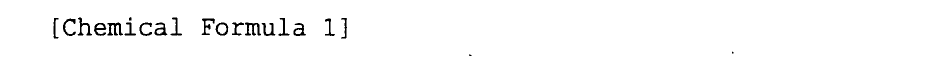 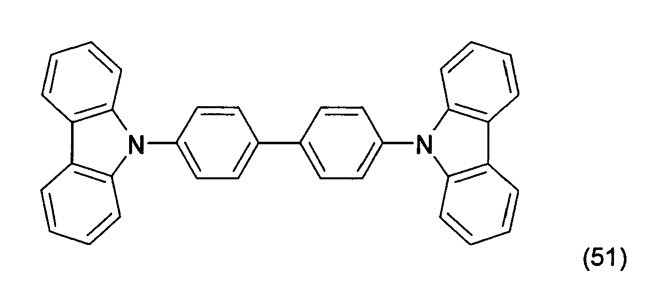 which is commonly known as a blue light emitting luminescent layer is used as a host material and iridium(III)bis[(4,6-difluorophenyl)-pyridinato-N,C^{2'}]picolinate <FIrpic> represented by the formula (21): 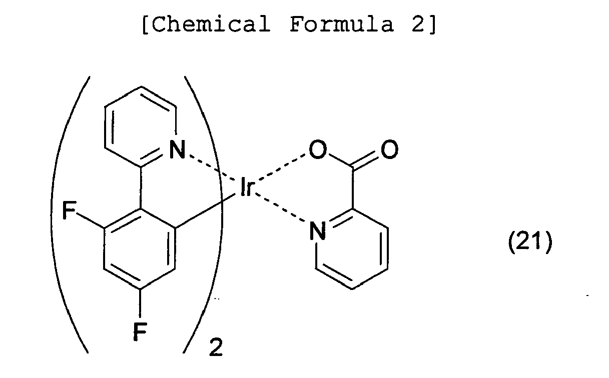 as a guest material is dispersed in a layer made of the host material, is about 5.7%, as is apparent from the results of Comparative Example 1 described hereinafter and a further improvement in luminescent efficiency is required.

Further the organic EL device has a problem that luminance drastically decrease when light is emitted for a long time, and an improvement of stability and extension of lifetime are also large objects. To achieve these objects, it is also required to improve durability of each layer constituting an electroluminescent layer.

### DISCLOSURE OF THE INVENTION

An object of the present invention is to provide an organic EL device which is excellent in luminescent efficiency, luminance and durability, particularly an organic EL device which has improved luminescent efficiency and luminance of blue color, which are the same as those of other colors, and is also is excellent in durability.

An invention described in claim 1 is an organic electroluminescent device comprising an electroluminescent layer having a single layer or a multilayered structure of two or more layers, a cathode for injecting electrons into the electroluminescent layer, and an anode for injecting holes into the electroluminescent layer, wherein the electroluminescent layer contains a pyridine derivative represented by the formula (1): 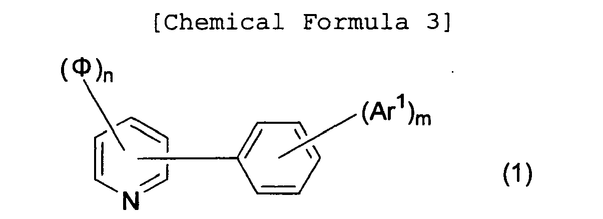 wherein Ar¹ represents an aryl group which may have a substituent; m represents an integer of 1 to 5 and, when m is an integer of 2 or more, each Ar¹ may be the same or different; Φ represents a group represented by the formula (1a) : 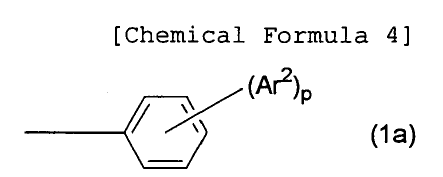 (wherein Ar² represents an aryl group which may have a substituent, p represents an integer of 1 to 5 and, when p is an integer of 2 or more, each Ar² may be the same or different), or
the formula (1b): 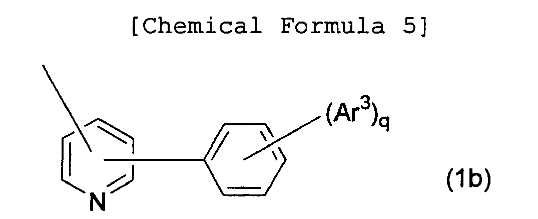 (wherein Ar³ represents an aryl group which may have a substituent, q represents an integer of 1 to 5 and, when q is an integer of 2 or more, each Ar³ may be the same or different); and n represents an integer of 0 to 2 and, when n is 2, each Φ may be the same or different.

An invention described in claim 2 is the organic electroluminescent device described in claim 1, wherein the pyridine derivative is a compound in which Ar¹ is a phenyl group, m is 4, and n is 0 in the formula (1).

An invention described in claim 3 is the organic electroluminescent device described in claim 2, wherein the pyridine derivative is at least one selected from the group consisting of a compound represented by the formula (11-1): 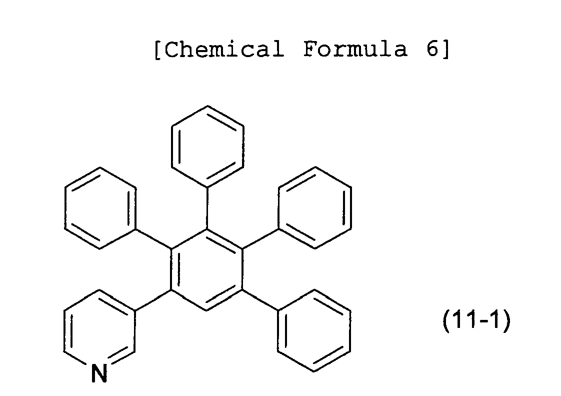 and a compound represented by the formula (11-2):

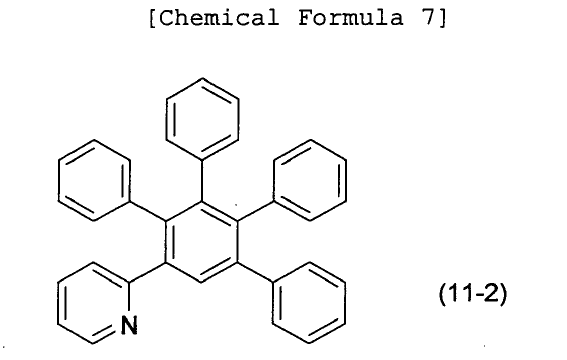

An invention described in claim 4 is the organic electroluminescent device described in claim 1, wherein the pyridine derivative is a compound in which Ar¹ is a phenyl group, m is 4, n is 1 and Φ is a group represented by the formula (1a) in the formula (1), and Ar² is a phenyl group and p is 4 in the formula (1a).

An invention described in claim 5 is the organic electroluminescent device described in claim 4, wherein the pyridine derivative is at least one selected from the group consisting of a compound represented by the formula (12-1): 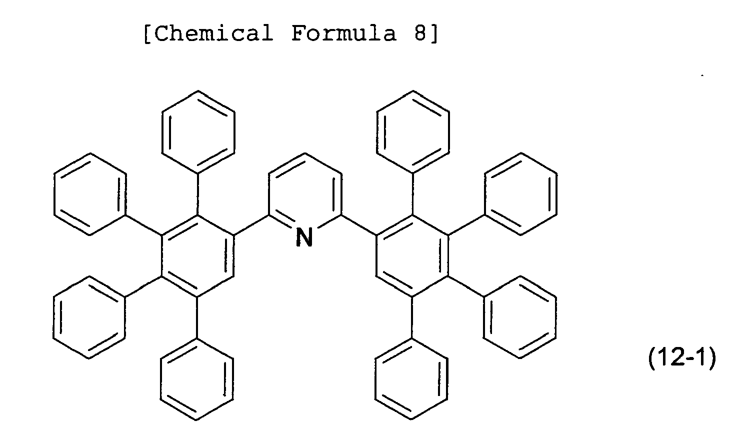 and a compound represented by the formula (12-2):

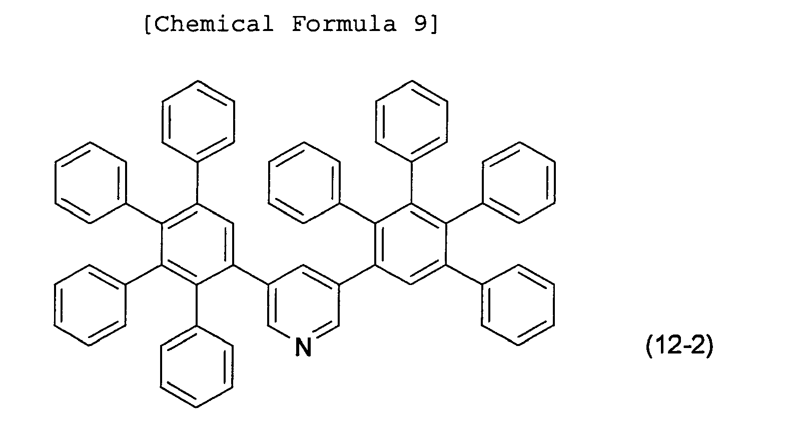

An invention described in claim 6 is the organic electroluminescent device described in claim 1, wherein the pyridine derivative is a compound in which Ar¹ is a phenyl group, m is 4, n is 1 and Φ is a group represented by the formula (1b) in the formula (1), and Ar³ is a phenyl group and q is 4 in the formula (1b).

An invention described in claim 7 is the organic electroluminescent device described in claim 6, wherein the pyridine derivative is a compound represented by the formula (13-1):

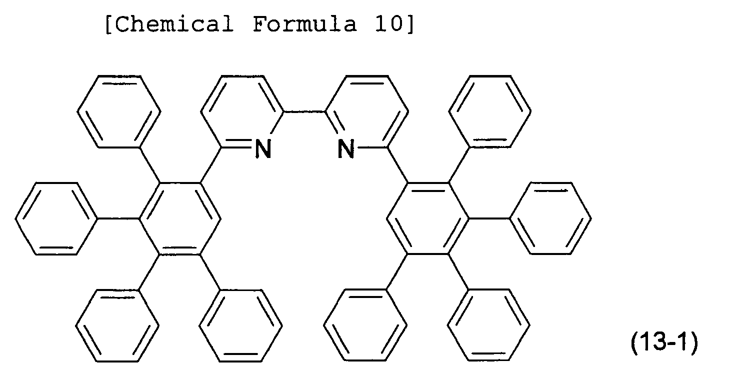

An invention described in claim 8 is the organic electroluminescent device described in claim 1, wherein the pyridine derivative is a compound in which Ar¹ is a phenyl group, m is 4 and n is 0 in the formula (1), and two Ar¹ among four Ar¹ are substituted with each one group represented by the formula (1c): 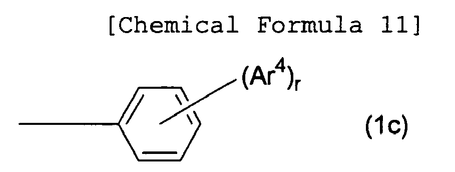 (wherein Ar⁴ represents an aryl group which may have a substituent, r represents an integer of 1 to 5 and, when r is an integer of 2 or more, each Ar⁴ may be the same or different), in which Ar⁴ is a phenyl group or a tolyl group, and r is 4 in the formula.

An invention described in claim 9 is the organic electroluminescent device described in claim 8, wherein the pyridine derivative is at least one selected from the group consisting of a compound represented by the formula (14-1): 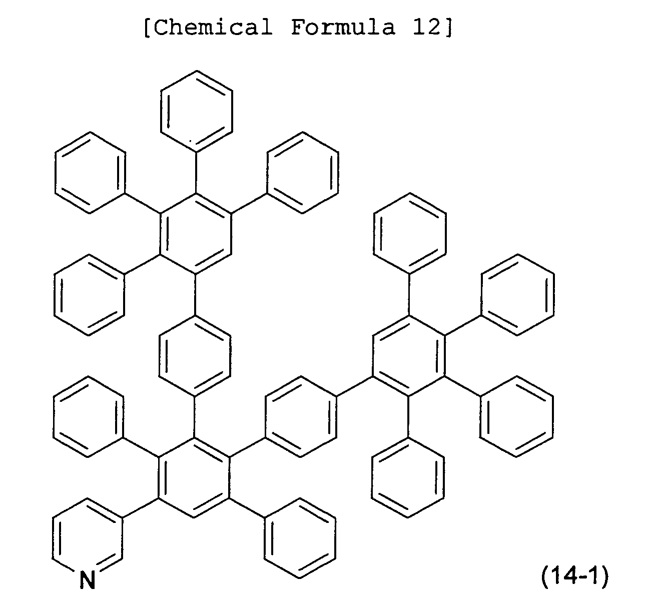 and a compound represented by the formula (14-2):

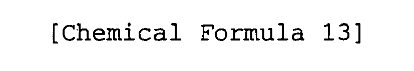

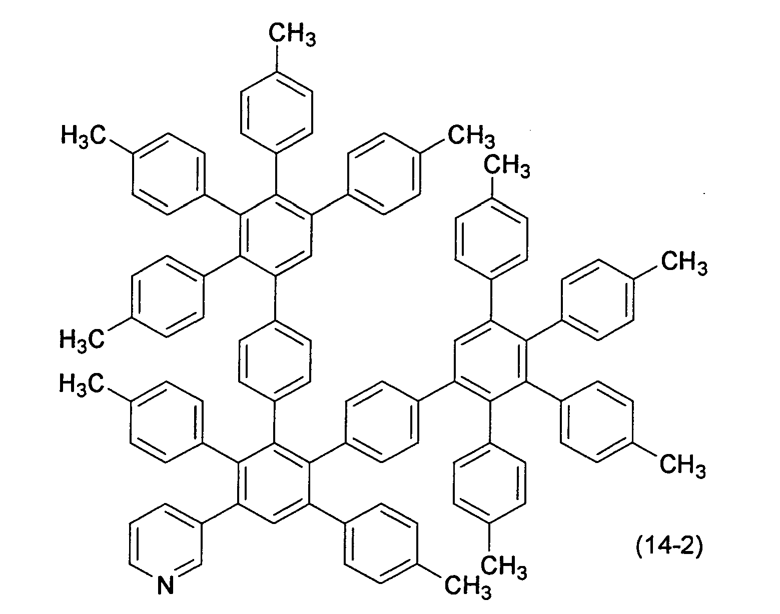

An invention described in claim 10 is the organic electroluminescent device described in claim 1, wherein the electroluminescent layer has a multilayered structure of two or more layers which contains a luminescent layer containing a luminescent material as a guest material and a pyridine derivative represented by the formula (1) as a host material.

An invention described in claim 11 is the organic electroluminescent device described in claim 10, which comprises, as the other layer constituting an electroluminescent layer having a multilayered structure together with the luminescent layer, at least one of an electron transporting layer formed between the luminescent layer and the cathode, and a hole transporting layer formed between the luminescent layer and the anode.

An invention described in claim 12 is the organic electroluminescent device described in claim 1, wherein the electroluminescent layer is a luminescent layer having a single layer which contains a luminescent material as a guest material and a pyridine derivative represented by the formula (1) as a host material.

An invention described in claim 13 is the organic electroluminescent device described in claim 1, wherein the electroluminescent layer has a multilayered structure of two or more layers which contains an electron transporting layer containing a pyridine derivative represented by the formula (1) as an electron transporting material.

An invention described in claim 14 is the organic electroluminescent device described in claim 13, which comprises, as the other layer constituting an electroluminescent layer having a multilayered structure together with the electron transporting layer, a luminescent layer formed between the electron transporting layer and the anode and a hole transporting layer formed between the luminescent layer and the anode.

An invention described in claim 15 is the organic electroluminescent device described in claim 13, which comprises, as the other layer constituting an electroluminescent layer having a multilayered structure together with the electron transporting layer, a hole transporting layer formed between the electron transporting layer and the anode, and either of the hole transporting layer and the electron transporting layer also serves as the luminescent layer.

### Effect of the Invention

As described in Japanese Patent Publication No. JP7-285937A, the present inventors noticed that a pyridine derivative having a skeleton of pyridine in the molecule has electron transportability and studied to achieve the above object by modifying the structure of the pyridine derivative. As a result, the inventors have found that a pyridine derivative represented by the formula (1) can be used.

That is, the pyridine derivative of the formula (1) does not form an exciplex for forming a trap of a carrier together with a luminescent material used as a host material which forms a luminescent layer together with the luminescent material, because of electron-withdrawing properties of a pyridine skeleton contained in the molecule. Although the pyridine derivative of the formula (1) having a plurality of plural aryl groups including a phenyl group bonded directly to the pyridine skeleton in the molecule, the pyridine skeleton inhibits formation of a large π-electron conjugated system over the plurality of plural aryl groups and thus each aryl group behaves similar to an independent aromatic compound. For example, a layer formed of a pyridine derivative, wherein all aryl groups are phenyl groups, has a function close to that of a benzene film which can not be converted into a solid film at the melting point or higher. Therefore, the pyridine derivative of the formula (1) exhibits a large energy gap and large quantum efficiency. In other words, it exhibits a high energy level as a host material.

Moreover, the pyridine derivative of the formula (1) has a relatively large molecular weight as compared with a conventional pyridine derivative such as pyridine derivative described in C. W. Tang and S. A. VanSlyke; Appl. Phys. Lett. , 51 (1987) 913 and is excellent in thermostability, and also exhibits large asymmetry of the molecule and low crystallinity, and therefore the pyridine derivative is also excellent in film forming properties in case of forming into a film by a vacuum deposition method. Therefore, it is possible to improve luminescent efficiency and luminance of an organic EL device than before by forming a photosensitive layer using the pyridine derivative of the formula (1) as a host material.

Since each aryl group behaves similar to the independent aromatic compound in the luminescent layer, as described above, when a group corresponding to an aromatic compound having an emission spectrum close to an emission wavelength of a luminescent material is selected as the aryl group, luminescent efficiency and luminance of the device can be further improved. When a luminescent layer is formed using the pyridine derivative of the formula (1), wherein a group corresponding to an aromatic compound having a blue emission spectrum, such as phenyl group corresponding to benzene is selected as an aryl group, in combination with a blue light emitting luminescent material as a guest material, luminescent efficiency and luminance of a blue light emitting organic EL device can be improved to the same level as that of devices of other colors.

Moreover, since the pyridine derivative of the formula (1) has a large molecular weight and is particularly excellent in thermostability within a normal temperature range (approximately 130°C or lower) of the organic EL device, durability within the above normal temperature range of a luminescent layer and an organic EL device having the luminescent layer can also be improved when the pyridine derivative of the formula (1) is used as a host material. Further, the pyridine derivative of the formula (1) has excellent electron transportability and, when an electron transporting layer is formed using the pyridine derivative as an electron transporting material, luminescent efficiency and luminance of the organic EL device can be improved by improving electron transporting characteristics of the electron transporting layer. It is also possible to improve durability of the electron transporting layer and the organic EL device.

### BRIEF DESCRIPTION OF THE DRAWINGS

Fig. 1 is a graph showing a relation between the applied voltage and the current density in an organic EL device comprising an electroluminescent layer including a luminescent layer, wherein a doping amount of a luminescent material is 6% by weight, produced in Example 1 of the present invention.
Fig. 2 is a graph showing a relation between the current density and the external quantum efficiency in the organic EL device.
Fig. 3 is a graph showing the results of the measurement of an emission spectrum of the organic EL device.
Fig. 4 is a graph showing a relation between the applied voltage and the current density in an organic EL device comprising an electroluminescent layer including a luminescent layer, wherein a doping amount of a luminescent material is 10% by weight, produced in Example 1 of the present invention.
Fig. 5 is a graph showing a relation between the current density and the external quantum efficiency in the organic EL device.
Fig. 6 is a graph showing the results of the measurement of an emission spectrum of the organic EL device.
Fig. 7 is a graph showing a relation between the applied voltage and the current density of an organic EL device produced in Example 2 of the present invention.
Fig. 8 is a graph showing a relation between the current density and the external quantum efficiency in the organic EL device.
Fig. 9 is a graph showing the results of the measurement of an emission spectrum of the organic EL device.
Fig. 10 is graph showing a relation between the applied voltage and the current density in an organic EL device produced in Example 3 of the present invention.
Fig. 11 is a graph showing a relation between the current density and the external quantum efficiency in the organic EL device.
Fig. 12 is a graph showing the results of the measurement of an emission spectrum of the organic EL device.
Fig. 13 is a graph showing a relation between the applied voltage and the current density in an organic EL device produced in Example 4 of the present invention.
Fig. 14 is a graph showing a relation between the current density and the external quantum efficiency in the organic EL device.
Fig. 15 is a graph showing the results of the measurement of an emission spectrum of the organic EL device.
Fig. 16 is a graph showing a relation between the applied voltage and the current density in an organic EL device produced in Example 5 of the present invention.
Fig. 17 is a graph showing a relation between the current density and the external quantum efficiency in the organic EL device.
Fig. 18 is a graph showing the results of the measurement of an emission spectrum of the organic EL device.
Fig. 19 is a graph showing a relation between the applied voltage and the current density in an organic EL device produced in Example 6 of the present invention.
Fig. 20 is a graph showing a relation between the current density and the external quantum efficiency in the organic EL device.
Fig. 21 is a graph showing the results of the measurement of an emission spectrum of the organic EL device.
Fig. 22 is a graph showing a relation between the applied voltage and the current density in an organic EL device produced in Example 7 of the present invention.
Fig. 23 is a graph showing a relation between the current density and the external quantum efficiency in the organic EL device.
Fig. 24 is a graph showing the results of the measurement of an emission spectrum of the organic EL device.
Fig. 25 is a graph showing a relation between the current density and the external quantum efficiency in an organic EL device produced in Comparative Example 1.

### DESCRIPTION OF THE PREFERRED EMBODIMENTS

As, described above, the organic EL device of the present invention comprises an electroluminescent layer having a single layer or a multilayered structure of two or more layers, a cathode for injecting electrons into the electroluminescent layer, and an anode for injecting holes into the electroluminescent layer, wherein the electroluminescent layer contains a pyridine derivative represented by the formula (1): 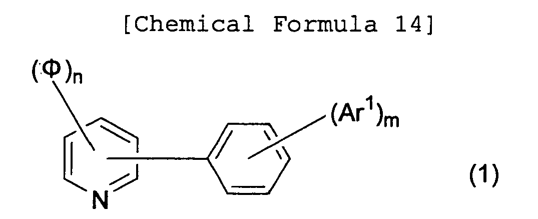 wherein Ar¹ represents an aryl group which may have a substituent; m represents an integer of 1 to 5 and, when m is an integer of 2 or more, each Ar¹ may be the same or different; Φ) represents a group represented by the formula (1a) : 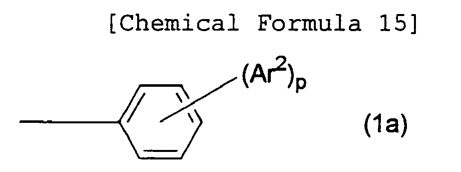 (wherein Ar² represents an aryl group which may have a substituent, p represents an integer of 1 to 5 and, when p is an integer of 2 or more, each Ar² may be the same or different), or
the formula (1b): 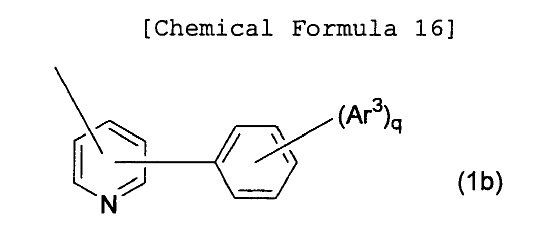 (wherein Ar³ represents an aryl group which may have a substituent, q represents an integer of 1 to 5 and, when q is an integer of 2 or more, each Ar³ may be the same or different), and n represents an integer of 0 to 2 and, when n is 2, each Φ may be the same or different.

### «Pyridine Derivative»

In the pyridine derivative represented by the formula (1), examples of an aryl group corresponding to Ar¹ to Ar³ include phenyl group, naphthyl group, biphenylyl group, o-terphenyl group, anthryl group and phenanthryl group. Example of a substituent, with which the aryl group may be substituted, corresponding to Ar¹ to Ar³ include an alkyl group having 1 to 6 carbon atoms such as methyl group, ethyl group, n-propyl group, i-propyl group, n-butyl group, i-butyl group, s-butyl group, t-butyl group, pentyl group or hexyl group, and a group represented by the formula (1c): 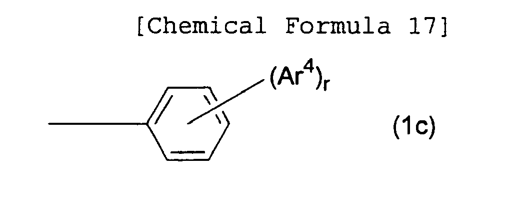 wherein Ar⁴ represents an aryl group which may have a substituent, r represents an integer of 1 to 5 and, when r is an integer of 2 or more, each Ar⁴ may be the same or different. One or more substituent can be substituted on one aryl group. Examples of the aryl group corresponding to Ar⁴ include the same groups as those described above. Examples of the substituent, with which the aryl group may be substituted, corresponding to Ar⁴ include the same alkyl groups as those described above.

The aryl group corresponding to Ar¹ to Ar⁴ is preferably a phenyl group, and the substitution numbers, m, p, and r are preferably 4 to 5 within the above range of 1 to 5, particularly preferably 4. The substitution position of four phenyl groups is preferably the 2-, 3-, 4- and 5 position of a central phenyl group as shown in the formula (10): 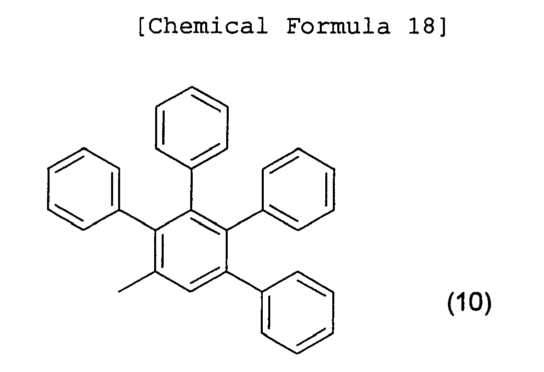 That is, a compound which has one or more pyridine and one or more group represented by the formula (10) (2,3,4,5-tetraphenylphenyl group) as a repeating unit respectively, is preferable as the pyridine derivative.

The pyridine derivative having such a repeating unit has high asymmetry of the molecule and has low crystallinity, and is also excellent in film forming properties and the effect of preventing formation of an exciplex by electron-withdrawing properties of a pyridine skeleton and the effect of inhibiting formation of a n-electron conjugated system by the pyridine skeleton. Moreover, the pyridine derivative has a lot of phenyl groups and therefore exhibits a high energy level to be used for a host material, and is also excellent in electron transportability to be used for an electron transporting material. Moreover, it has a large molecular weight and is also excellent in thermostability.

Specific examples of the pyridine derivative represented by the formula (1) include the following respective compounds.

A compound represented by the formula (11-1) <3G1-pyridine> and a compound represented by the formula (11-2) <2G1-pyridine>, wherein Ar¹ is a phenyl group, m is 4 and n is 0 in the formula (1) (these compounds have one pyridine and one repeating unit represented by the formula (10)).

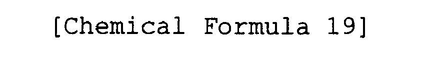

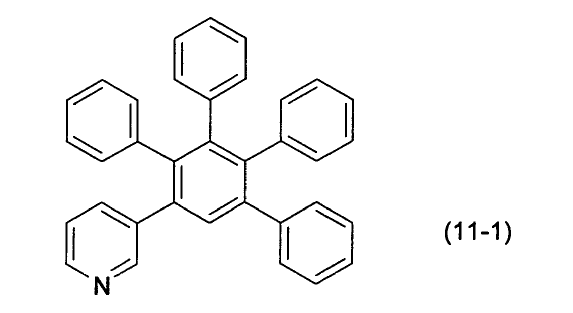

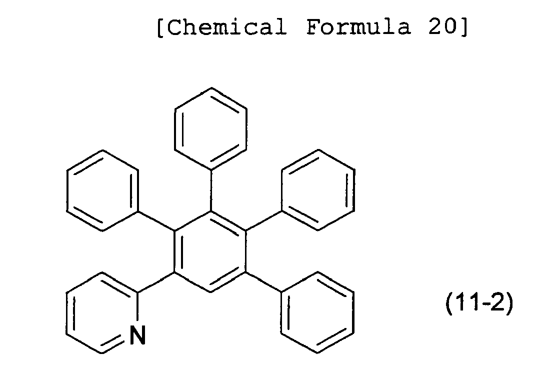

A compound represented by the formula (12-1) <2,6G1-pyridine> and a compound represented by the formula (12-2) <3,5G1-pyridine>, wherein Ar¹ is a phenyl group, m is 4, n is 1, and Φ is a group represented by the formula (1a) in the formula (1), and Ar² is a phenyl group and p is 4 in the formula (1a) (these compounds have one pyridine and two repeating units represented by the formula (10)).

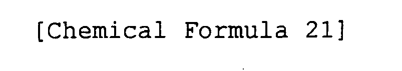

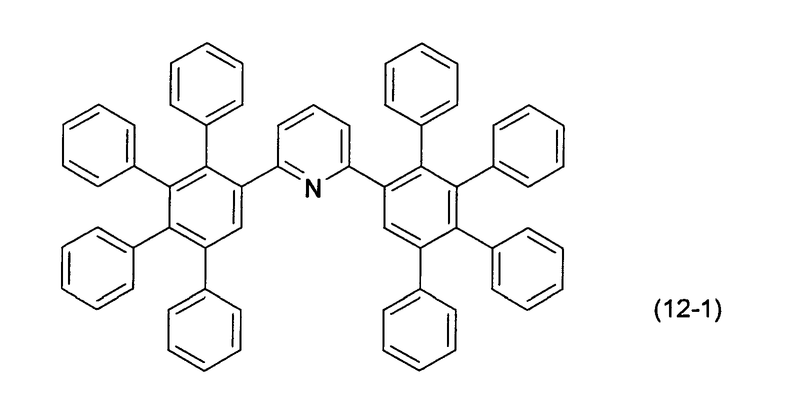

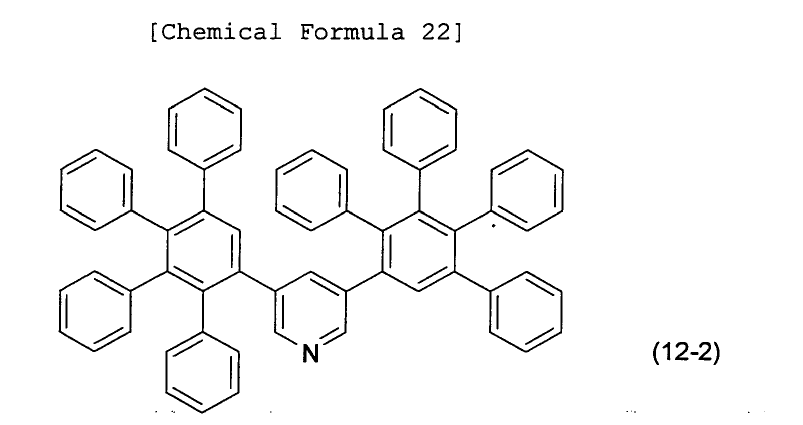

A compound represented by the formula (13-1) <2,2' G1-pyridine> wherein Ar¹ is a phenyl group, m is 4, n is 1 and Φ is a group represented by the formula (1b) in the formula (1), and Ar³ is a phenyl group and q is 4 in the formula (1b) (the compound have one pyridine and two repeating units represented by the formula (10)).

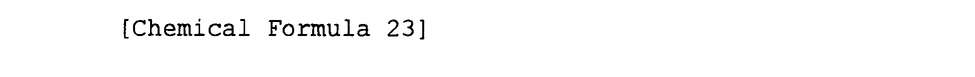

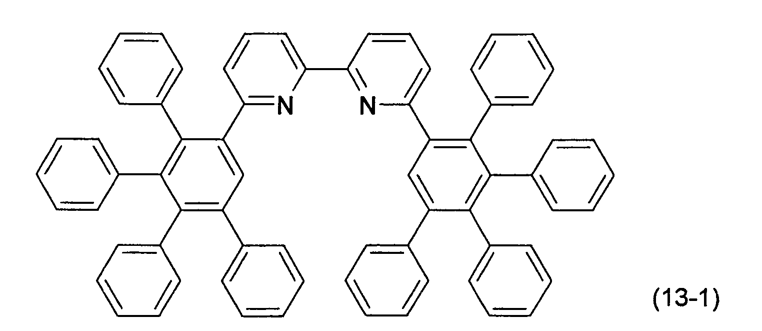

A compound represented by the formula (14-1) <3G2-pyridine> wherein Ar¹ is a phenyl group, m is 4 and n is 0 in the formula (1) and two Ar¹ among four Ar¹ are substituted with each one group represented by the formula (1c) wherein Ar⁴ is a phenyl group and r is 4, and a compound represented by the formula (14-2) <3G2*-pyridine> wherein each one methyl group as a substituent is substituted on an outermost phenyl group of 3G2-pyridine (these compounds have one pyridine and three repeating units represented by the formula (10)).

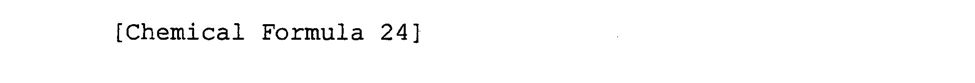

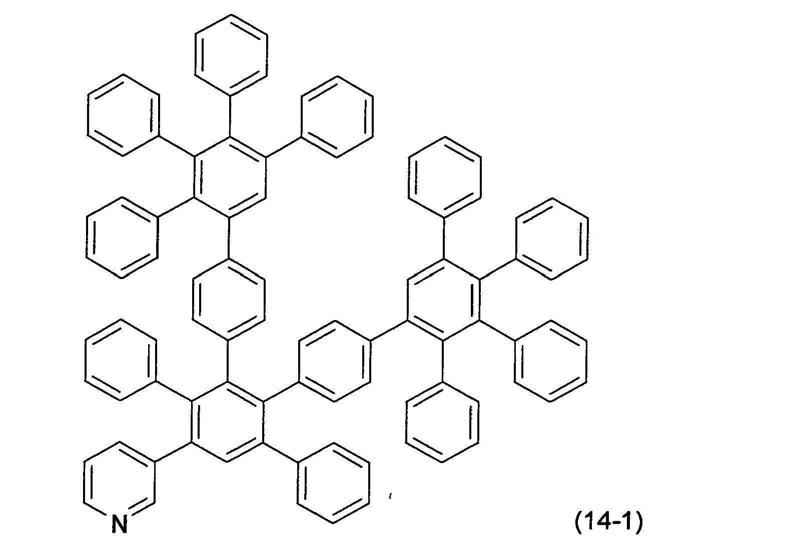

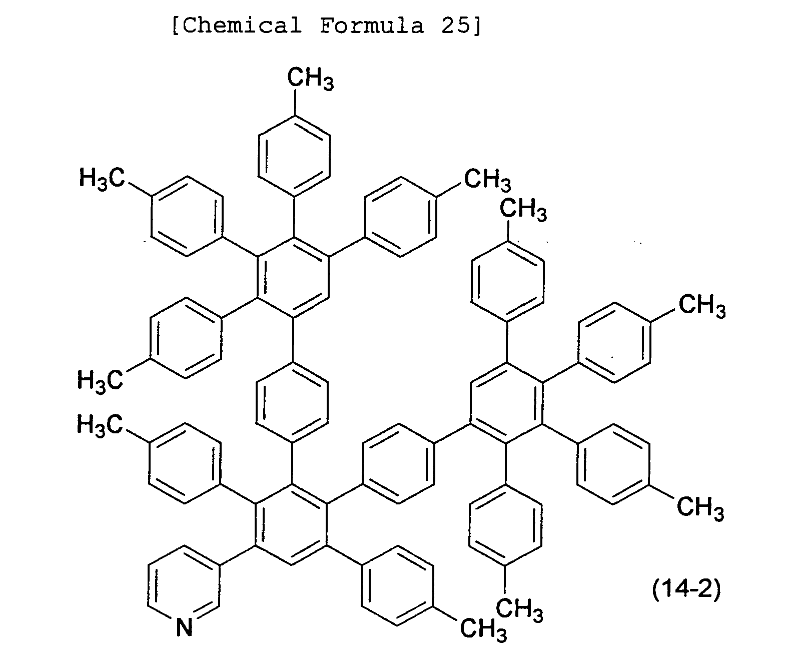

These specific compounds can be synthesized by the method described in "Hogeneous Palladium Catalyst Suppressing Pd Black Formation in Air Oxidation of Alcohols" Tetsuo Iwasawa, Makoto Tokunaga, Yasushi Obora, and Yasushi Tsuji; and J. AM. CHEM. SOC. 2004, 126, 6554-6555.

### «Organic EL Device»

The electroluminescent layer containing the pyridine derivative of the formula (1) may have a single layer or a multilayered structure of two or more layers. When the electroluminescent layer has a multilayered structure of two or more layers, the pyridine derivative of the formula (1) can contain in any one layer or two or more layers of a luminescent layer, a hole transporting layer and an electron transporting layer.

When the luminescent layer contains the pyridine derivative of the formula (1), the luminescent layer includes a layer having a structure wherein a luminescent material having phosphorescence or fluorescence as a guest material is dispersed in a layer formed using the pyridine derivative of the formula (1) as a host material. The luminescent layer having such a structure can be formed by forming the pyridine derivative of the formula (1) into a film using various film forming methods, for example, a vapor growth method such as vacuum deposition method, and a solution coating method for coating a solution containing the pyridine derivative of the formula (1) and drying the solution, and doping with a luminescent material.

As described previously, since the pyridine derivative represented by the formula (1) exhibits a high energy level to be used for a host material and is also excellent in film forming properties and thermostability, an organic EL device comprising an electroluminescent layer having a multilayered structure, including a luminescent layer having the above structure, has high luminescent efficiency, high luminance and is also excellent in durability. When, a compound having a blue emission spectrum, for example, a compound wherein all aryl groups corresponding to Ar¹ to Ar⁴ are phenyl groups, such as compound represented by any one of the formulas (11-1) to (14-1) is selected as the pyridine derivative of the formula (1) and used in combination with a blue light emitting luminescent material as a guest material, a blue light emitting organic EL device having high luminescent efficiency and high luminance, which are the same as those of devices of other colors such as red and green colors, can also be formed. Regarding the pyridine derivative represented by the formula (1) and the luminescent material, two or more kinds of them may be used in combination so as to adjust the emission wavelength.

The content ratio of the luminescent material in the luminescent layer is preferably from 0.1 to 30% by weight, and more preferably from 0.1 to 10% by weight, based on the total amount of the pyridine derivative of the formula (1) and the luminescent material. When the content ratio of the luminescent material is less than the above range, luminescent efficiency and luminance of the device may decrease, resulting in insufficient light emission. On the other hand, when the content ratio is more than the above range, since the amount of the pyridine derivative of the formula (1) is insufficient, luminescent efficiency and luminance of the device may decrease instead, resulting in insufficient light emission. Further, durability of the device may deteriorate.

As the luminescent material, any of various organic metal complexes and organic metal compounds each having phosphorescence or fluorescence can be used. Examples of the phosphorescent luminescent material include organic metal complexes containing platinum group devices such as iridium (Ir), platinum (Pt), ruthenium (Ru) and osmium (Os), and gold (Au). Examples of the organic metal complex containing platinum among these luminescent materials include 2,3,7,8,12,13,17,18-octaethyl-12H,23H-porphyrin platinum and [2-(4',6'-difluorophenyl)-pyridinato-N,C^{2'}]platinum.

Examples of the organic metal complex containing iridium include iridium(III)bis[(4,6-difluorophenyl)-pyridinato-N,C^{2'}]picolinate <FIrpic> represented by the formula (21), iridium(III)bis(4',6'-difluorophenylpyridinato)tetrakis(1-pyrazolyl)borate <FIr6> represented by the formula (22) and bis[2-(3,5-bistrifluoromethyl-phenyl)-pyridinato-N,C^{2'}]iridium(III)picolinate <(CF₃ppy)₂Ir(pic)> represented by the formula (23) [these complexes emit lightblue]; fac-tris-(2-phenylpyridine)iridium(III) <Ir(ppy)₃> represented by the formula (24) and bis(2-phenylpyridine)iridium(III)acetylacetonate <Ppy₂Ir(acac)> represented by the formula (25) [these complexes emit light green]; bis(2-phenylbenzothiazolato-N, C^{2'}) iridium (III) acetylacetonate <Bt₂Ir (acac) > represented by the formula (26) [this complex emits light yellow]; and bis[2-(2'-benzo(4,5-a)thienyl)pyridinato-N,C^{3'}] iridium (III) acetylacetonate <Btp₂Ir (acac) > represented by the formula (27) and iridium (III) bis (dibenzo [f,h] quinozaline) acetylacetonate <Ir(DBQ)₂(acac)> represented by the formula (28) [these complexes emit light red].

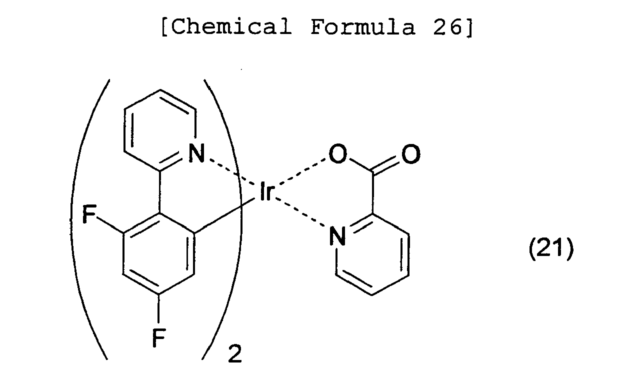

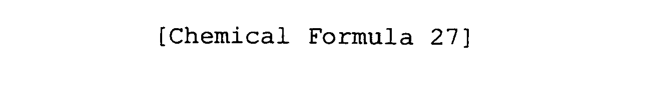

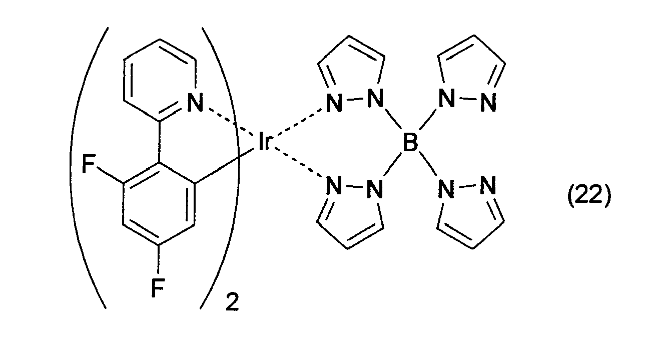

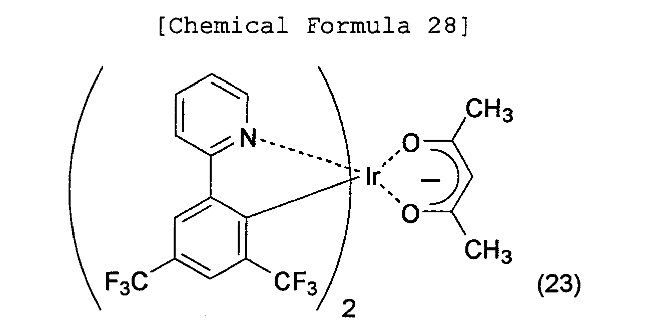

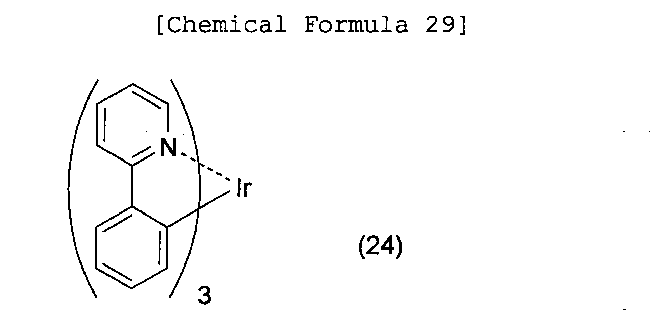

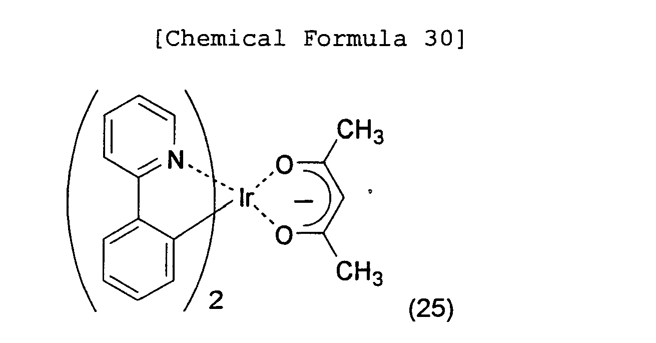

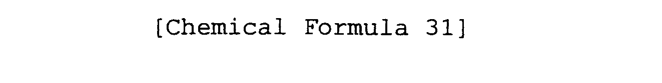

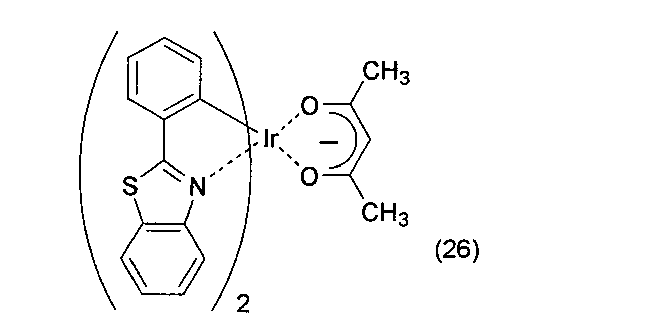

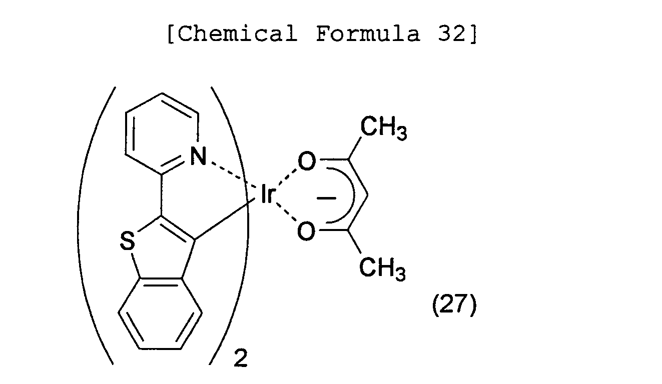

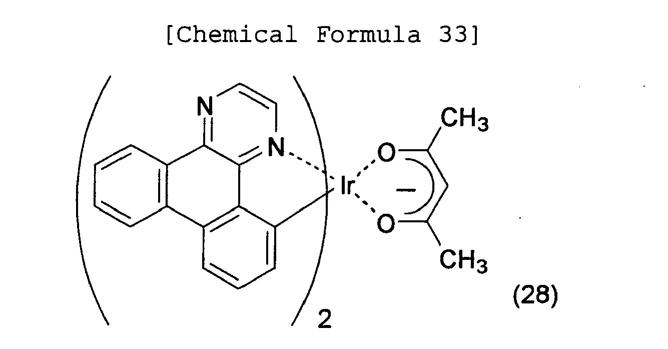

Examples of the fluorescent luminescent material include tris(8-quinolinolato)aluminum(III)complex <Alq₃> represented by the formula (29) [this material emits light green].

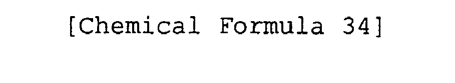

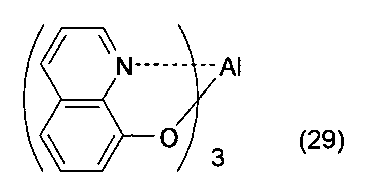

The luminescent layer can be doped with a laser pigment so as to adjust the emission wavelength of the luminescent layer. Examples of the laser pigment include 4-(dicyanomethylene)-2-methyl-6-(julolidin-4-yl-vinyl)-4H-pyran <DCM2> represented by the formula (31) [this pigment emits light red], cumarin 6 represented by the formula (32) [this pigment emits light green] and perylene represented by the formula (33) [this pigment emits light blue].

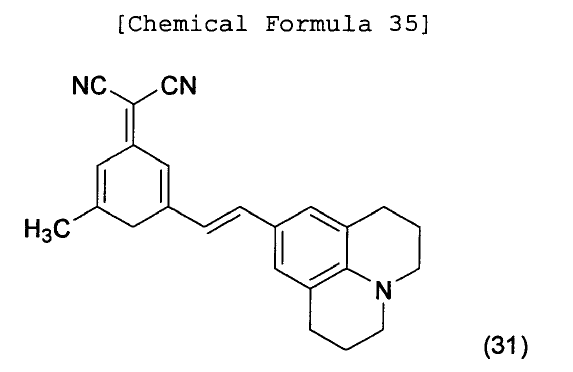

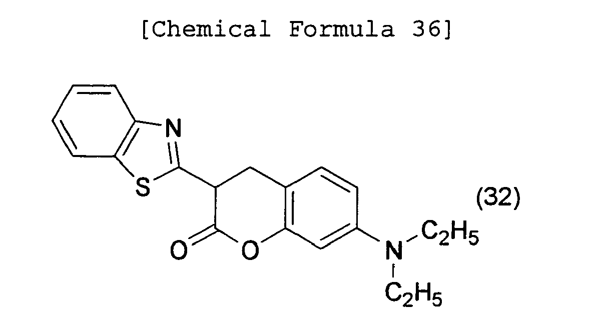

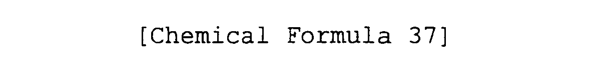

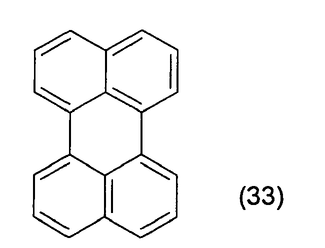

The thickness of the luminescent layer is preferably from 1 to 50 nm, and more preferably from 5 to 30 nm. When the thickness of the luminescent layer is less than the above range, luminescent efficiency may decrease. On the other hand, when the thickness is more tan the above range, a drive voltage may increase.

Examples of the other layer, which constitutes the electroluminescent layer having a multilayered structure together with the luminescent layer, include an electron transporting layer formed between a luminescent layer and a cathode, and a hole transporting layer formed between a luminescent layer and an anode. Examples of the electron transporting material constituting the electron transporting layer include 2-(4'-t-butylphenyl)-5-(4"-biphenyl)-1,3,4-oxadiazole <PBD> represented by the formula (41), 3-(4-biphenylyl)-4-phenyl-5-(4-t-butylphenyl)-1,2,4-triazole <TAZ> represented by the formula (42), 4,7-diphenyl-1,10-phenanthroline <Bphen> represented by the formula (43), 2,9-dimethyl-4,7-diphenyl-1,10-phenanthroline <BCP> by the formula (44), and bis(2-methyl-8-quinolinolato-N1,08)-(1,1'-biphenyl-4-olate)aluminum <BAlQ₂> by the formula (45). Alq₃ represented by the formula (29) can also be used as the electron transporting material.

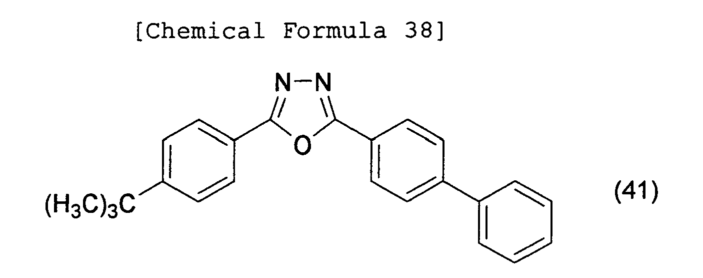

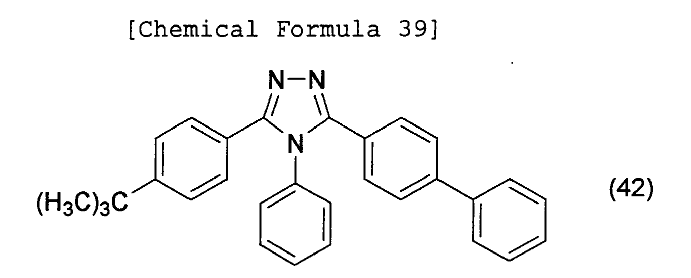

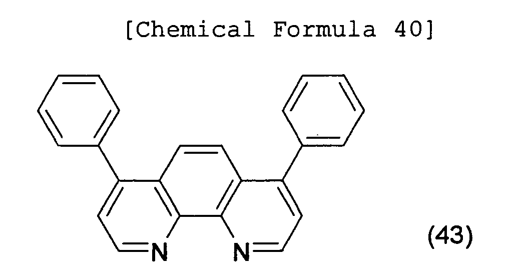

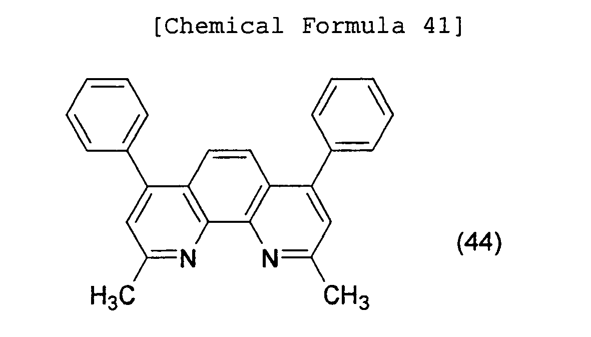

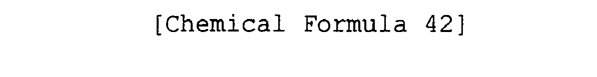

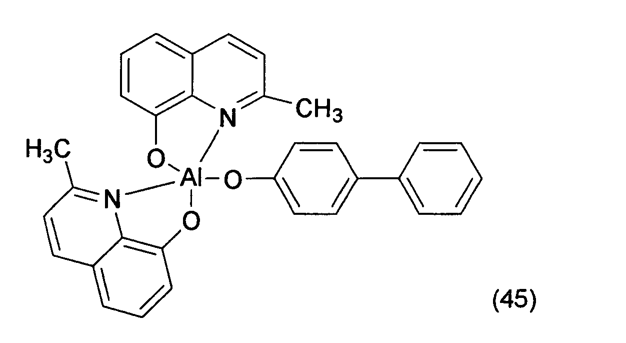

The electron transporting layer may have a single layer, or a multilayered structure of an original electron transporting layer, and an electron injecting layer and a hole inhibiting layer, which assist the original electron transporting layer. The electron injecting layer is a layer which is formed between an electron transporting layer and a cathode to assist injection of electrons from the cathode to the electron transporting layer, and is preferably formed of BAlQ₂ represented by the formula (45), which is excellent in the function of assisting injection of electrons, among various electron transporting materials listed above.

The hole inhibiting layer is a layer which is formed between an electron transporting layer and a luminescent layer to prevent holes injected from an anode to a luminescent layer, from escaping to a cathode without recombining with electrons, and is particularly preferably formed of TAZ represented by the formula (42), Bphen represented by the formula (43), or BCP represented by the formula (44), which is excellent in the function of blocking holes, among various electron transporting materials listed above.

The electron transporting layer of a single layer and each layer for forming the electron transporting layer having a multilayered structure can be formed by a vapor growth method such as vacuum deposition method, or a solution coating method. The thickness of the single-layered electron transporting layer is preferably from 1 to 50 nm, and more preferably from 5 to 20 nm. When the thickness of the electron transporting layer is less than the above range, electron injection efficiency may become insufficient and the effect of confining holes may become insufficient. On the other hand, when the thickness is more than the above range, a drive voltage may increase.

The thickness of the original electron transporting layer as a main part among the electron transporting layer having a multilayered structure is preferably from 1 to 20 nm, and more preferably from 5 to 10 nm. When the thickness of the electron transporting layer is less than the above range, electron injection efficiency may become insufficient and the effect of confining holes may become insufficient. On the other hand, when the thickness is more than the above range, a drive voltage may increase.

The thickness of the electron injecting layer is preferably from 1 to 50 nm, and more preferably from 5 to 20 nm. When the thickness of the electron injecting layer is less than the above range, sufficient effect of injecting electrons from the cathode to the electron transporting layer by the electron injecting layer may not be obtained. On the other hand, when the thickness is more than the above range, a drive voltage may decrease.

Furthermore, the thickness of the hole inhibiting layer is preferably from 1 to 50 nm, and more preferably from 5 to 20 nm. When the thickness of the hole inhibiting layer is less than the above range, sufficient effect of preventing holes from escaping to the cathode by the hole inhibiting layer may not be obtained. On the other hand, when the thickness is more than the above range, a drive voltage may decrease.

Examples of the hole transporting material, which forms the hole transporting layer constituting the electroluminescent layer having a multilayered structure together with the luminescent layer, include 4,4'-di(N-carbazolyl)biphenyl <CBP> represented by the formula (51), N,N'-diphenyl-N,N'-bis(3-methylphenyl)-1,1'-biphenyl-4,4'-diamine <TPD> represented by the formula (52), 4,4'-bis [N-(1-naphthyl)-N-phenylamino]biphenyl <α-NPD> represented by the formula (53), and 4,4',4"-tris [N-(3-methylphenyl)-N-phenylamino]triphenylamine <m-MTDATA> represented by the formula (54).

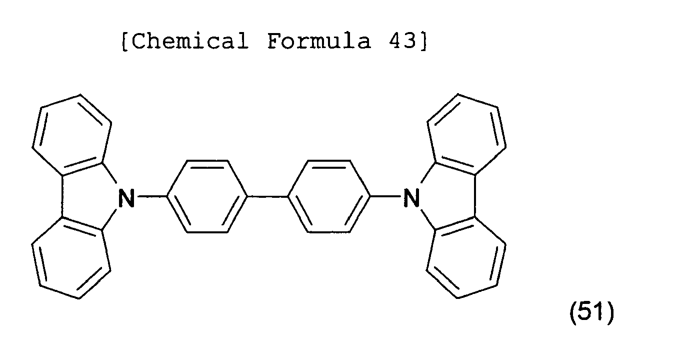

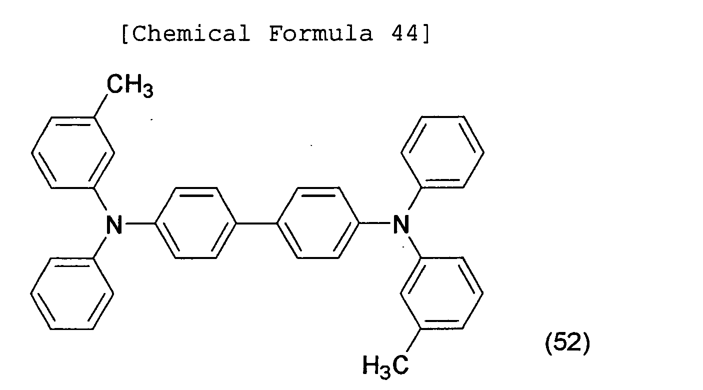

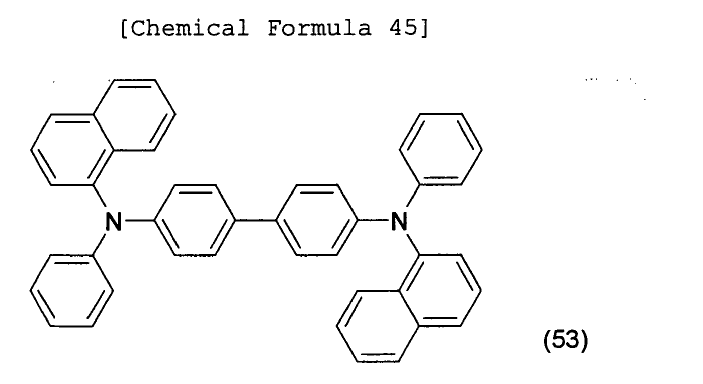

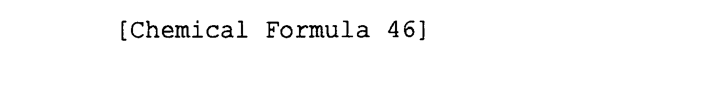

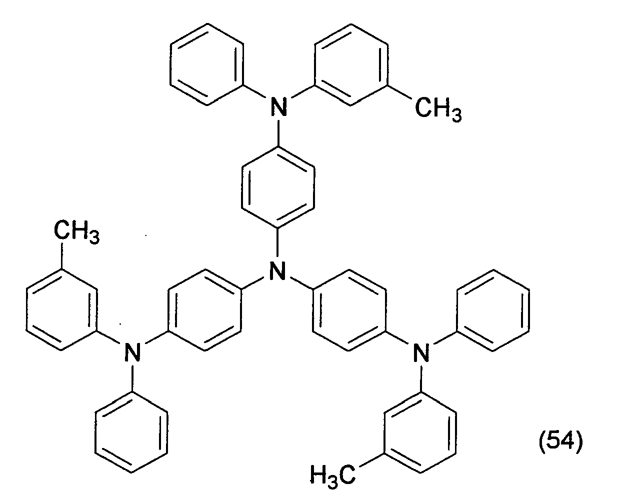

The hole transporting layer may have a single layer, or a multilayered structure of an original hole transporting layer, and a hole injecting layer and an electron inhibiting layer, which assist the original hole transporting layer. The hole injecting layer is a layer which is formed between a hole transporting layer and an anode to assist injection of electrons from the anode to the hole transporting layer, and is preferably formed of the respective compounds represented by the formulas (51) to (54) which are excellent in the function of assisting injection of holes, or copper phthalocyanine (CuPC) represented by the formula (55).

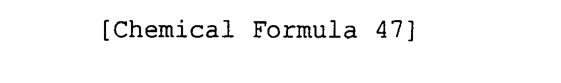

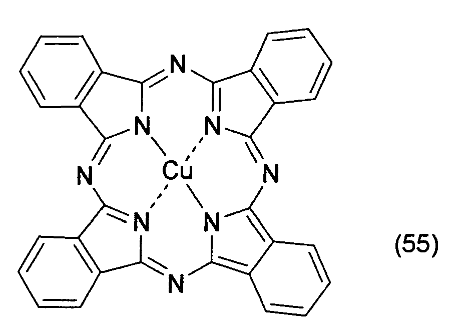

The electron inhibiting layer is a layer which is a layer formed between a hole transporting layer and a luminescent layer to prevent electrons injected from a cathode to a luminescent layer from escaping to an anode without recombining with holes, and is preferably formed of 1,3-di(N-carbazolyl)phenyl (mCP) represented by the formula (56), which is excellent in the function of blocking holes.

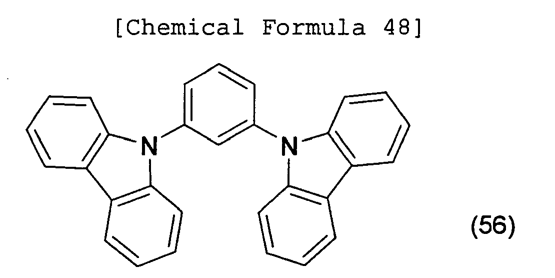

The hole transporting layer of a single layer and the respective layers of the hole transporting layer having a multilayered structure can be formed by a vapor growth method such as vacuum deposition method, or a solution coating method. The thickness of the single layered hole transporting layer is preferably from 1 to 50 nm, and more preferably from 5 to 20 nm. When the thickness of the hole transporting layer is less than the above range, hole injection efficiency may decrease. On the other hand, when the thickness is more than the above range, a drive voltage may increase.

Further, the thickness of the original hole transporting layer as a main part among the hole transporting layer having a multilayered structure is preferably form 1 to 20 nm, and more preferably from 5 to 10 nm. When the thickness of the hole transporting layer is less than the above range, hole injection efficiency may decrease. On the other hand, when the thickness is more than the above range, a drive voltage may increase.

The thickness of the hole injecting layer is preferably from 1 to 50 nm, and more preferably from 5 to 20 nm. When the thickness of the hole injecting layer is less than the above range, sufficient effect of injecting holes from the anode into the hole transporting layer by the hole injecting layer may not be obtained. On the other hand, when the thickness is more than the above range, a drive voltage may increase.

Furthermore, the thickness of the electron inhibiting layer is preferably from 1 to 50 nm, and more preferably from 2 to 50 nm. When the thickness of the electron inhibiting layer is less than the above range, sufficient effect of preventing electrons from escaping to the anode by the electron inhibiting layer may not be obtained. On the other hand, when the thickness is more than the above range, a drive voltage may increase.

When the electron transporting layer among the electroluminescent layer having a multilayered structure contains the pyridine derivative of the formula (1), the electron transporting layer includes a layer obtained by forming the pyridine derivative of the formula (1) into a film using a vapor growth method such as vacuum deposition method, or a solution coating method.

As described previously, since the pyridine derivative represented by the formula (1) is excellent in electron transportability, film forming properties and thermostability, an organic EL device comprising an electroluminescent layer having a multilayered structure, including the above electron transporting layer having the structure, has high luminescent efficiency, high luminance and excellent durability.

The electron transporting layer containing the pyridine derivative of the formula (1) is a single layer and may be combined with a luminescent layer or a hole transporting layer to form an electroluminescent layer, or may be combined with the above described electron injecting layer and the hole inhibiting layer to form an electron transporting layer having a multilayered structure, or may be combined with a luminescent layer and a hole transporting layer to form an electroluminescent layer. Further, the pyridine derivative of the formula (1) is excellent in the function of blocking holes and therefore the hole inhibiting layer containing the pyridine derivative of the formula (1) may be combined with an electron transporting layer made of other electron transporting material to form an electron transporting layer having a multilayered structure, which may be combined with a luminescent layer and a hole transporting layer to form an electroluminescent layer.

The luminescent layer to be combined with the electron transporting layer may be a luminescent layer containing the pyridine derivative of the formula (1), and may be combined with a luminescent layer with conventionally known various constitutions.

That is, it is possible to combine a luminescent layer having a structure wherein the various luminescent materials described above, as a guest material, are dispersed in a layer formed using, as a host material, a phenylcarbazole derivative such as CBP represented by the formula (51), mCP represented by the formula (56), or 2,2'-dimethyl-4,4'-di(N-carbazolyl)biphenyl <CDBP> represented by the formula (57): 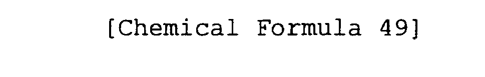 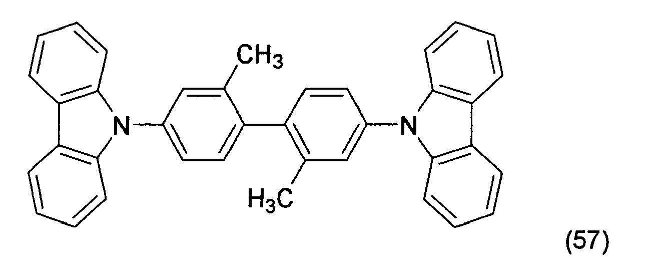 or an arylsilane compound such as diphenyldi(o-tolyl)silane <UGH1> represented by the formula (58): 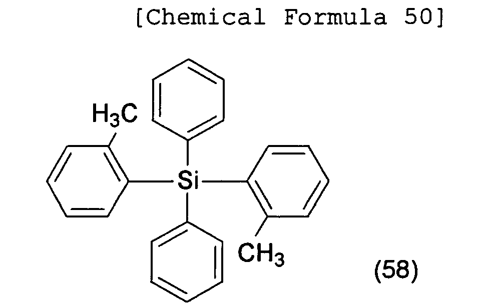 or p-bis(triphenylsilyl)benzene <UGH2> represented by the formula (59):

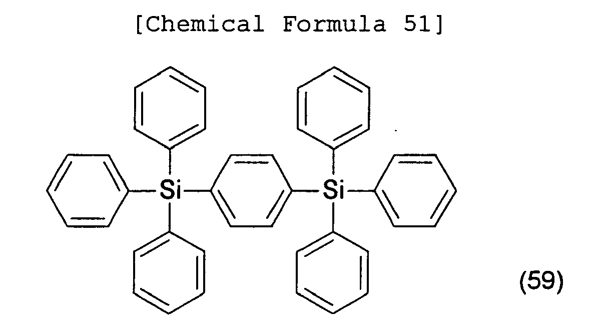

As the hole transporting layer, the above described hole transporting layer having a single layered structure or a multilayered structure can be combined.

Specific examples of the electroluminescent layer including an electron transporting layer containing the pyridine derivative of the formula (1) include a layer having a two-layered structure of the electron transporting layer and the hole transporting layer (the hole transporting layer and the electron transporting layer may be a single layer or may have a multilayered structure), either of which also serves as a luminescent layer, and a layer having a three-layered structure of an electron transporting layer, a luminescent layer and a hole transporting layer (the hole transporting layer and the electron transporting layer may be a single layer or may have a multilayered structure).

The thickness of the single layered electron transporting layer is preferably from 1 to 50 nm, and more preferably from 20 to 50 nm. When the thickness of the electron transporting layer is less than the above range, electron injection efficiency may decrease. On the other hand, when the thickness is more than the above range, a drive voltage may increase.

The thickness of the original electron transporting layer as a main part among the electron transporting layer having a multilayered structure is preferably from 1 to 50 nm, and more preferably from 5 to 20 nm. When the thickness of the electron transporting layer is less than the above range, electron injection efficiency may decrease. On the other hand, when the thickness is more than the above range, a drive voltage may increase.

The electroluminescent layer having a single layer of the pyridine derivative of the formula (1) can be constituted in the same manner as in case of the luminescent layer contained in the electroluminescent layer having a multilayered structure. That is, the electroluminescent layer having a single layer includes a layer having a structure wherein the luminescent material described above is dispersed in a layer formed using the pyridine derivative of the formula (1) as a host material.

Since the pyridine derivative represented by the formula (1) exhibits a high energy level to be used for a host material and is also excellent in film forming properties and thermostability as described above, an organic EL device comprising an electroluminescent layer consisting of a single layer having the above structure has high luminescent efficiency, high luminance and excellent durability.

When a compound having a blue emission spectrum, for example, a compound wherein an aryl group in the formula (1) is a phenyl group, such as compound represented by any one of the formulas (11-1) to (14-1) is selected and used in combination with a blue light emitting luminescent material as a guest material, a blue light emitting organic EL device having high luminescent efficiency and high luminance, which are the same level as that of devices of other colors such as red and green colors.

The electroluminescent layer having a single layer having such a structure can be formed by forming into a film using various film forming method, for example, a vapor growth method such as vacuum deposition method, and a solution coating method of coating a solution containing the pyridine derivative of the formula (1) and drying the solution, and doping with a luminescent material.

The content of the luminescent material in the electroluminescent layer having a single layer is preferably from 0.1 to 30% by weight, and more preferably from 0.1 to 10% by weight, based on the total amount of the pyridine derivative of the formula (1) and the luminescent material. When the content of the luminescent material is less than the above range, luminescent efficiency and luminance of the device may decrease, resulting in insufficient light emission. On the other hand, when the content is more than the above range, since the amount of the pyridine derivative of the formula (1) is insufficient, luminescent efficiency and luminance of the device may decrease instead, resulting in insufficient light emission. Further, durability of the device may deteriorate.

The thickness of the electroluminescent layer having a single layer is preferably from 10 to 200 nm, and more preferably from 50 to 100 nm. When the thickness is less than the above range, luminescent efficiency may decrease. On the other hand, when the thickness is more than the above range, a drive voltage may increase.

As long as the effects of the present invention are not adversely affected and deteriorated, other compounds having the same function as that of the pyridine derivative in each layer may be added to the layer containing the pyridine derivative represented by the formula (1) among the electroluminescent layer having a multilayered structure and the electroluminescent layer having a single layer. That is, the luminescent layer and the hole transporting layer among the electroluminescent layer having a multilayered structure, and the electroluminescent layer having a single layer may contain compounds represented by the formulas (51) and (56) to (59), which serve as a host material, together with the pyridine derivative of the formula (1). Further, the electron transporting layer among the electroluminescent layer having a multilayered structure may contain compounds represented by the formulas (29) and (41) to (44), together with the pyridine derivative of the formula (1)

Taking account of an improvement efficiency of injection of electrons into an electroluminescent layer, the cathode having the organic EL device together with the electroluminescent layer is preferably made of a material having a small work function and, for example, a thin film made of magnesium, aluminum, lithium, indium, a magnesium-aluminum alloy, a magnesium-silver alloy or an aluminum-lithium alloy is preferably used as the cathode. On the cathode, a protective layer made of silver may be formed.

Taking account of an improvement of efficiency of injection of holes into an electroluminescent layer, an anode is preferably made of a material having a large work function, on the other hand. Further, taking account of efficient extract light from the electroluminescent layer out of the device, a thin film made of an indium-tin complex oxide (ITO) is preferably used as a cathode.

### EXAMPLES

### <Example 1>

The following respective layers were sequentially formed on a glass substrate by a vacuum deposition method to produce an organic EL device comprising an electroluminescent layer including a multilayered structure of four layers. A doping amount (content ratio) of a luminescent material in a luminescent layer was adjusted to 6% by weight or 10% by weight based on the total amount of 3G1-pyridine represented by the formula (11-1) and a luminescent material.
Anode: 110 nm thick ITO layer
Hole transporting layer: 50 nm thick α-NPD layer represented by the formula (53).
Luminescent layer: 20 nm thick layer formed by doping a layer made of 3G1-pyridine represented by the formula (11-1) as a host material with Ir(ppy)₃ represented by the formula (24) as a guest material (luminescent material)
Hole inhibiting layer: 10 nm thick BCP layer represented by the formula (44)
Electron transporting layer: 30 nm thick Alq₃ layer represented by the formula (29)
Cathode: 100 nm thick magnesium-silver alloy layer
Protective layer: 10 nm thick silver layer

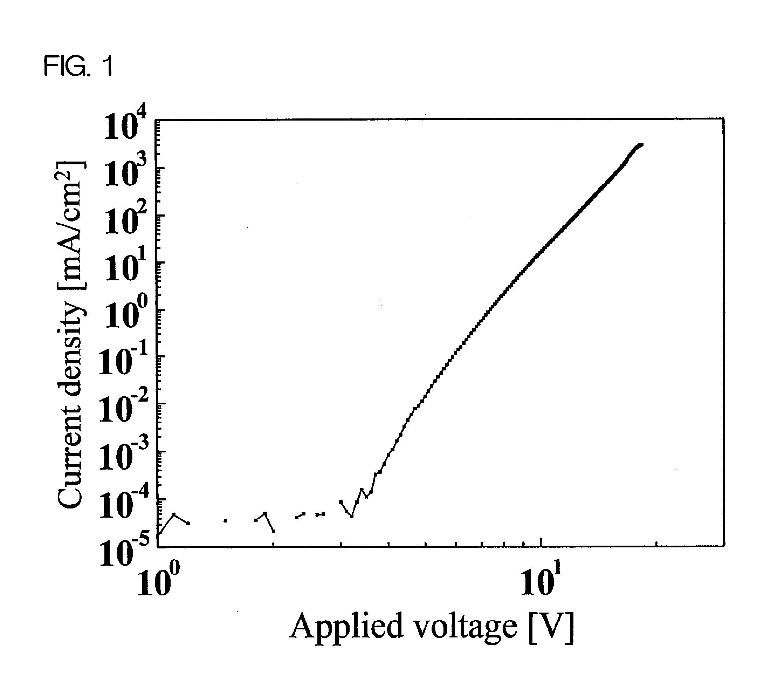

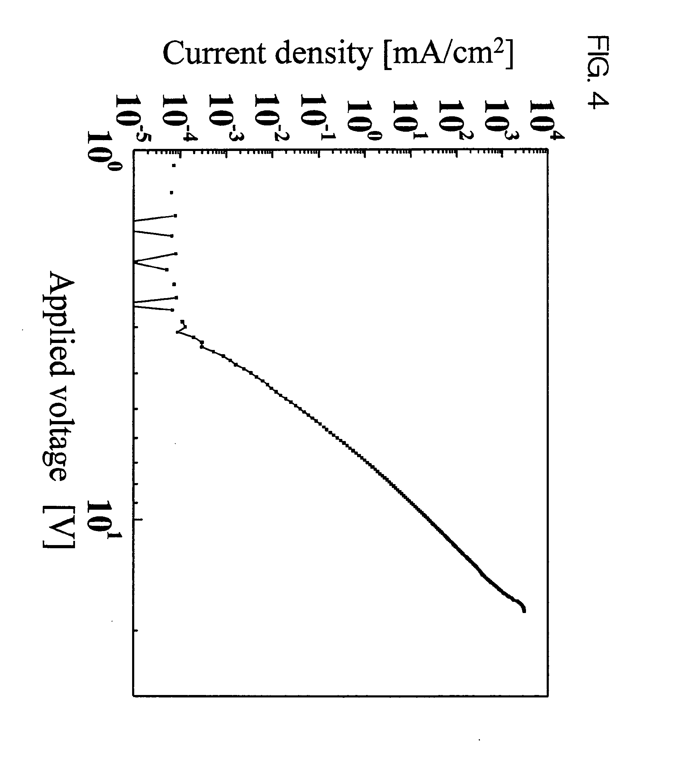

A cathode and an anode of the organic EL device were connected to a DC power supply and DC voltage was applied to an electroluminescent layer in an atmospheric air at room temperature (23±1°C) to emit light. As a result, when a doping amount of the luminescent material was adjusted to 6% by weight, the results shown in Figs. 1 to 3 were obtained and when the doping amount was adjusted to 10% by weight, the results shown in Figs. 4 to 6 were obtained.

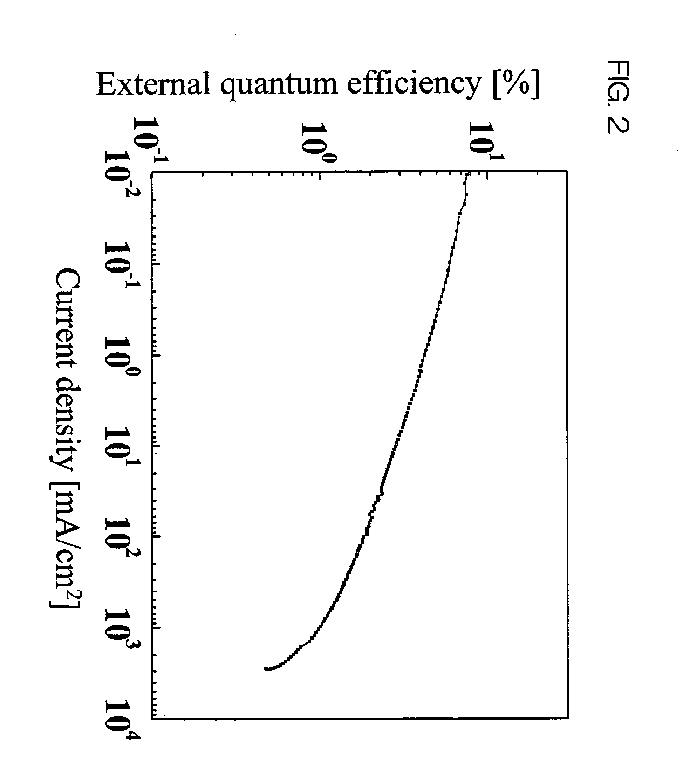

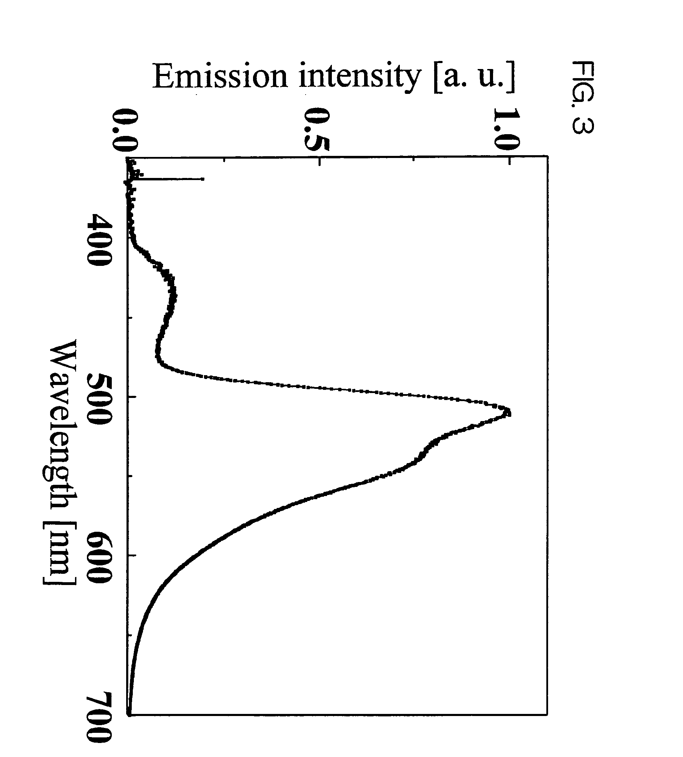

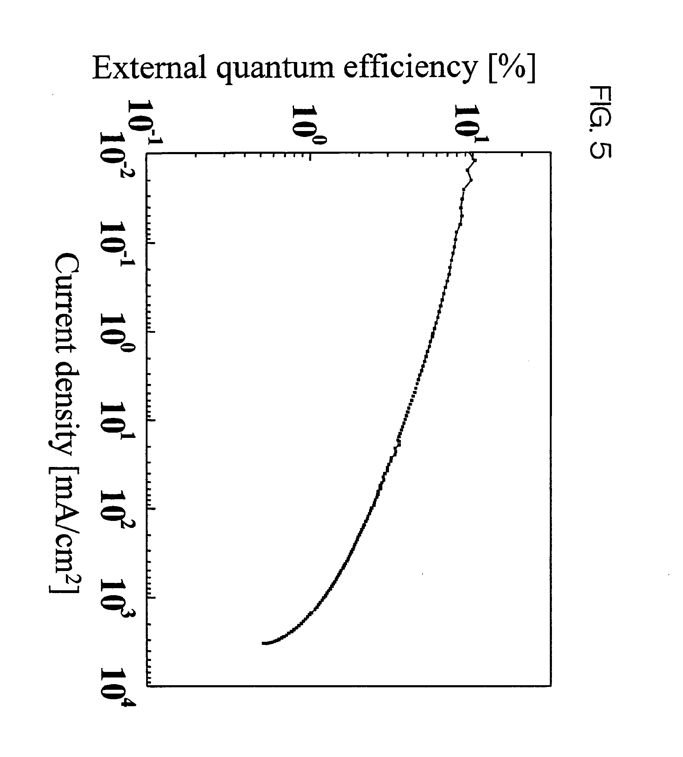

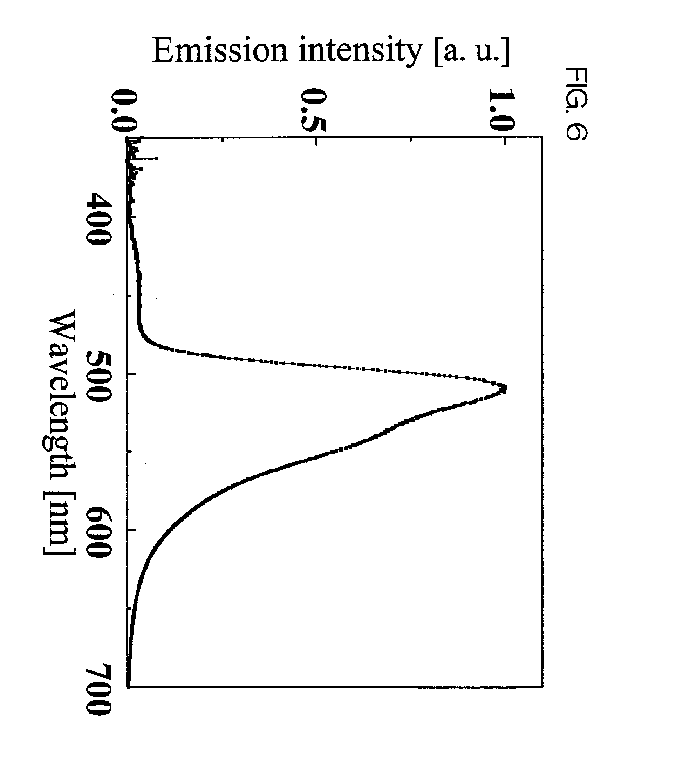

Figs. 1 and 4 are graphs showing a relation between the applied voltage and the current density, Figs. 2 and 5 are graphs showing a relation between the current density and the external quantum efficiency, and Figs. 3 and 6 are graphs showing the results of the measurement of the emission spectrum of the device, respectively. As is apparent from these drawings, the results confirmed that, according to the constitution of Example 1, even if a doping amount of a luminescent material is 6% by weight, it is possible to make an organic EL device to emit green light with high luminescent efficiency, that is, external quantum efficiency close to 10%, and that luminescent efficiency can be further improved by increasing the doping amount of the luminescent material to 10% by weight.

### <Example 2>

The following respective layers were sequentially formed on a glass substrate by a vacuum deposition method to produce an organic EL device comprising an electroluminescent layer including a multilayered structure of four layers. An doping amount (content ratio) of a luminescent material in a luminescent layer was adjusted to 10% by weight based on the total amount of 3G1-pyridine represented by the formula (11-1) and a luminescent material.
Anode: 110 nm thick ITO layer
Hole transporting layer: 50 nm thick TPD layer represented by the formula (52)
Luminescent layer: 20 nm thick layer formed by doping a layer made of 3G1-pyridine represented by the formula (11-1) as a host material with Ir(ppy)₃ represented by the formula (24) as a guest material (luminescent material)
Hole inhibiting layer: 10 nm thick BCP layer represented by the formula (44)
Electron transporting layer: 30 nm thick Alq₃ layer represented by the formula (29)
Cathode: 100 nm thick magnesium-silver alloy layer
Protective layer: 10 nm thick silver layer

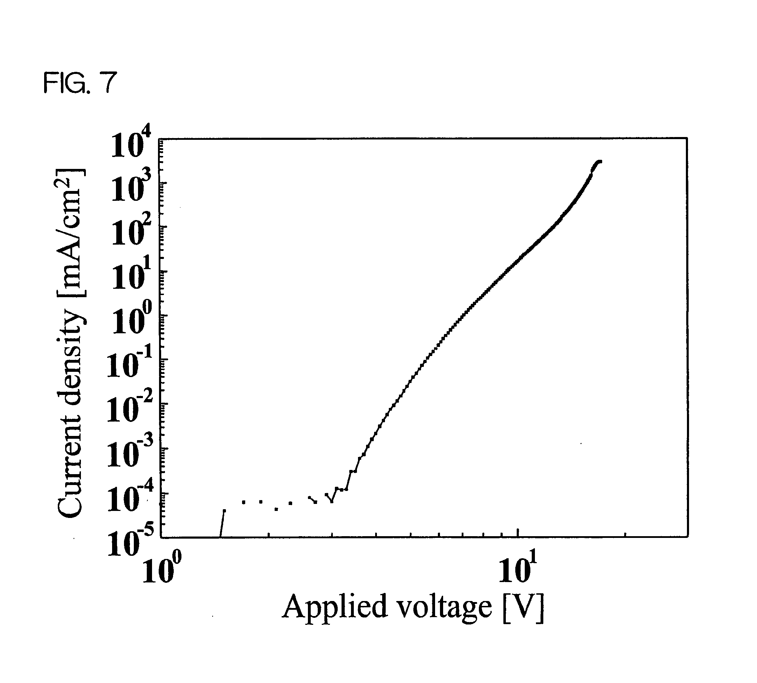

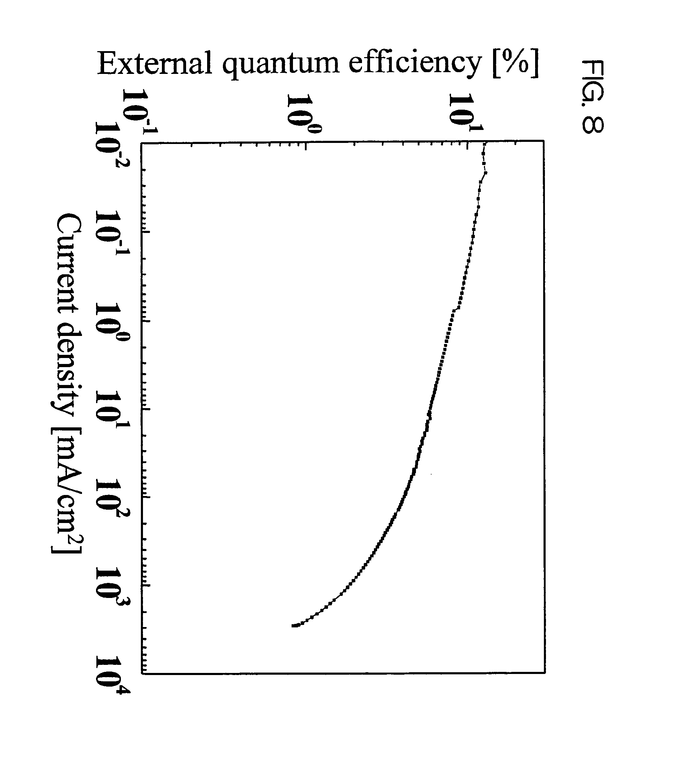

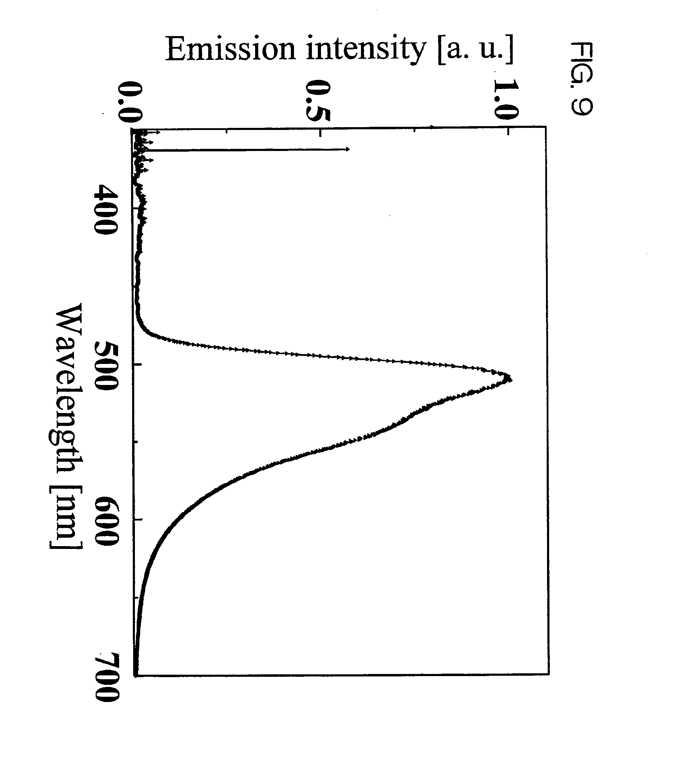

A cathode and an anode of the organic EL device were connected to a DC power supply and DC voltage was applied to an electroluminescent layer in an atmospheric air at room temperature (23±1°C) to emit light. As a result, the results shown in Figs. 7 to 9 were obtained. Fig. 7 is a graph showing a relation between the applied voltage and the current density, Fig. 8 is a graph showing a relation between the current density and the external quantum efficiency, and Fig. 9 is a graph showing the results of the measurement of the emission spectrum of the device, respectively. As is apparent from these drawings, the results confirmed that, according to the constitution of Example 2, it is possible to make an organic EL device to emit green light with high luminescent efficiency, that is, external quantum efficiency of 10% or more.

### <Example 3>

The following respective layers were sequentially formed on a glass substrate by a vacuum deposition method to produce an organic EL device comprising an electroluminescent layer including a multilayered structure of three layers. A doping amount (content ratio) of a luminescent material in a luminescent layer was adjusted to 10% by weight based on the total amount of 3G1-pyridine represented by the formula (11-1) and a luminescent material.
Anode: 110 nm thick ITO layer
Hole transporting layer: 50 nm thick TPD layer represented by the formula (52)
Luminescent layer: 20 nm thick layer formed by doping a layer made of 3G1-pyridine represented by the formula (11-1) as a host material with Ir(ppy)₃ represented by the formula (24) as a guest material (luminescent material)
Electron transporting layer: 40 nm thick Bphen layer represented by the formula (43)
Cathode: 100 nm thick magnesium-silver alloy layer
Protective layer: 10 nm thick silver layer

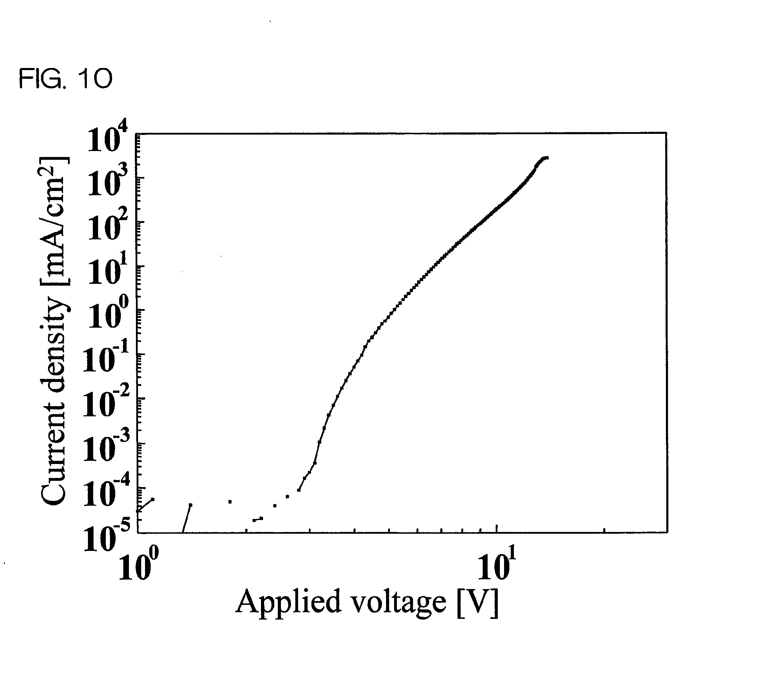

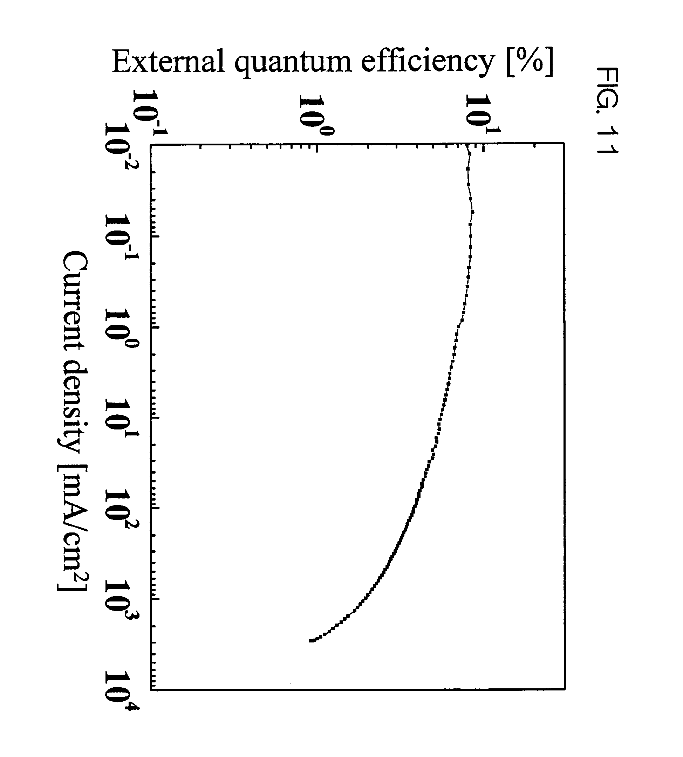

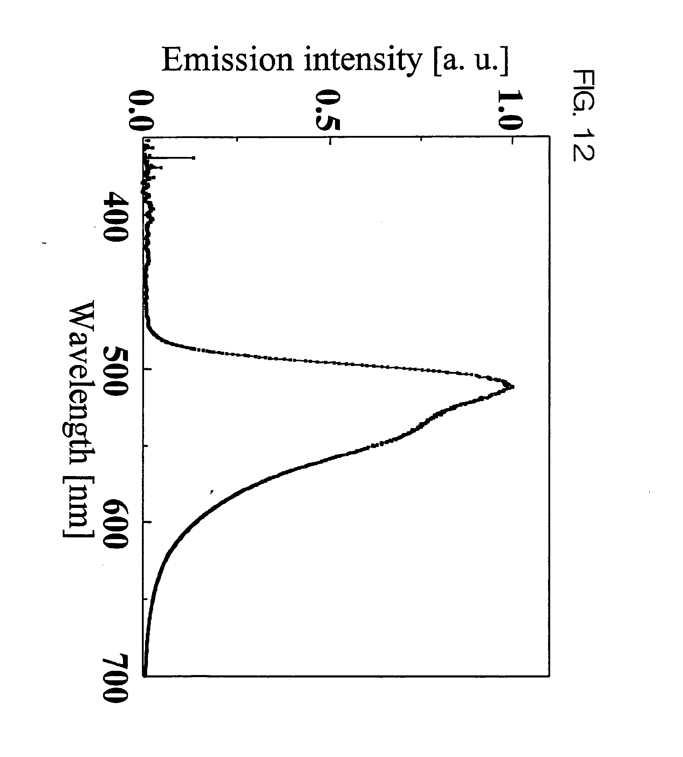

A cathode and an anode of the organic EL device were connected to a DC power supply and DC voltage was applied to an electroluminescent layer in an atmospheric air at room temperature (23±1°C) to emit light. As a result, the results shown in Figs. 10 to 12 were obtained. Fig. 10 is a graph showing a relation between the applied voltage and the current density, Fig. 11 is a graph showing a relation between the current density and the external quantum efficiency, and Fig. 12 is a graph showing the results of the measurement of the emission spectrum of the device, respectively. As is apparent from these drawings, the results confirmed that, according to the constitution of Example 3, it is possible to make an organic EL device to emit green light with high luminescent efficiency, that is, external quantum efficiency close to 10%.

### <Example 4>

The following respective layers were sequentially formed on a glass substrate by a vacuum deposition method to produce an organic EL device comprising an electroluminescent layer including a multilayered structure of four layers. A doping amount (content ratio) of a luminescent material in a luminescent layer was adjusted to 6% by weight based on the total amount of 2,6G1-pyridine represented by the formula (12-1) and a luminescent material.
Anode: 110 nm thick ITO layer
Hole transporting layer: 50 nm thick α-NPD layer represented by the formula (53)
Luminescent layer: 20 nm thick layer formed by doping a layer made of 2,6G1-pyridine represented by the formula (12-1) as a host material with Ir(ppy)₃ represented by the formula (24) as a guest material (luminescent material)
Hole inhibiting layer: 10 nm thick BCP layer represented by the formula (44)
Electron transporting layer: 30 nm thick Alq₃ layer represented by the formula (29)
Cathode: 100 nm thick magnesium-silver alloy layer
Protective layer: 10 nm thick silver layer

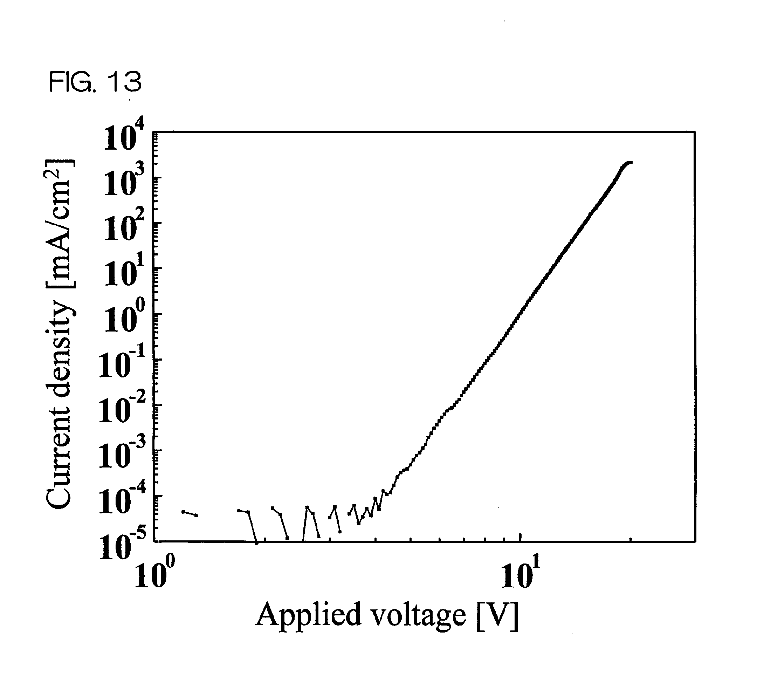

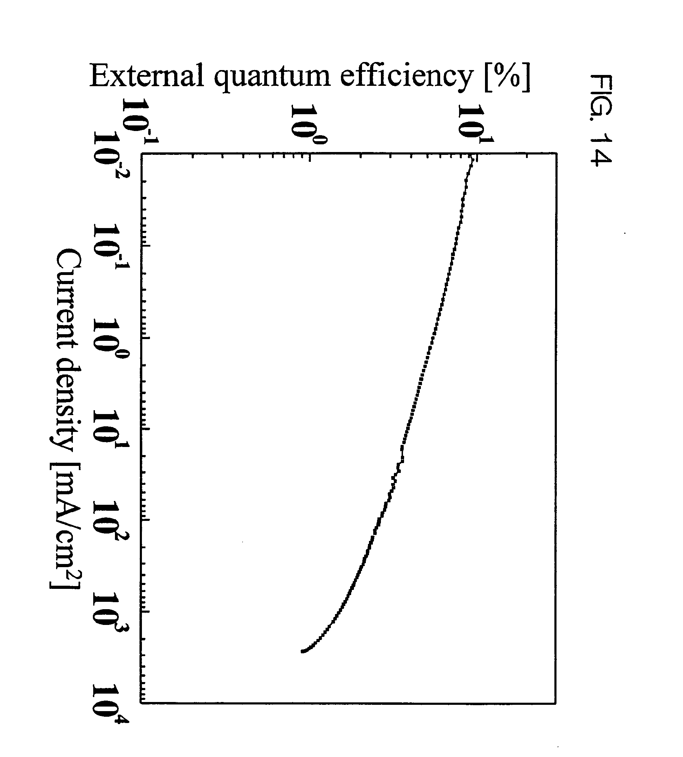

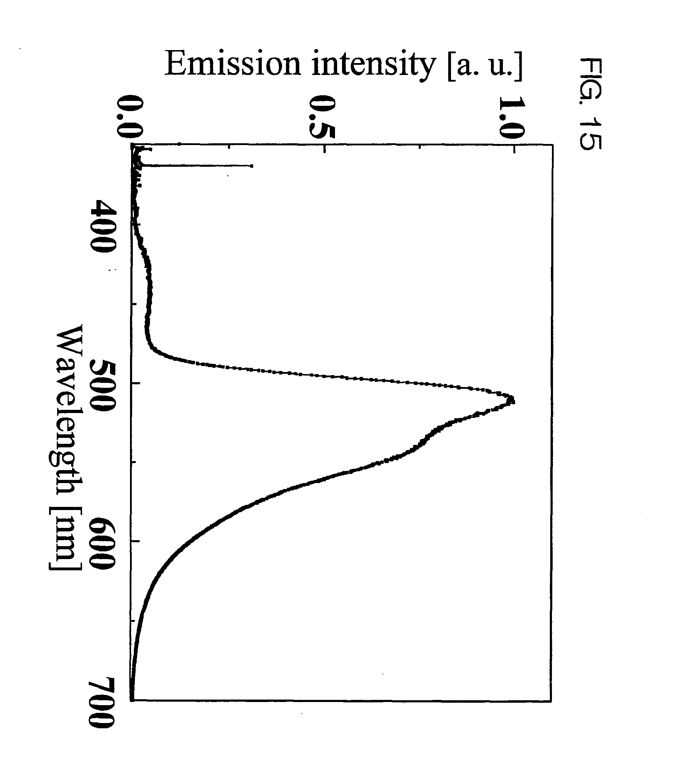

A cathode and an anode of the organic EL device were connected to a DC power supply and DC voltage was applied to an electroluminescent layer in an atmospheric air at room temperature (23±1°C) to emit light. As a result, the results shown in Figs. 13 to 15 were obtained. Fig. 13 is a graph showing a relation between the applied voltage and the current density, Fig. 14 is a graph showing a relation between the current density and the external quantum efficiency, and Fig. 15 is a graph showing the results of the measurement of the emission spectrum of the device, respectively. As is apparent from these drawings, the results confirmed that, according to the constitution of Example 4, it is possible to make an organic EL device to emit green light with high luminescent efficiency, that is, external quantum efficiency close to 10%.

### <Example 5>

The following respective layers were sequentially formed on a glass substrate by a vacuum deposition method to produce an organic EL device comprising an electroluminescent layer including a multilayered structure of four layers. A doping amount (content ratio) of a luminescent material in a luminescent layer was adjusted to 6% by weight based on the total amount of 2,2' G1-pyridine represented by the formula (13-1) and a luminescent material.
Anode: 110 nm thick ITO layer
Hole transporting layer: 50 nm thick α-NPD layer represented by the formula (53)
Luminescent layer: 20 nm thick layer formed by doping a layer made of 2,2'G1-pyridine represented by the formula (13-1) as a host material with Ir(ppy)₃ represented by the formula (24) as a guest material (luminescent material)
Hole inhibiting layer: 10 nm thick BCP layer represented by the formula (44)
Electron transporting layer: 30 nm thick Alq₃ layer represented by the formula (29)
Cathode: 100 nm thick magnesium-silver alloy layer
Protective layer: 10 nm thick silver layer

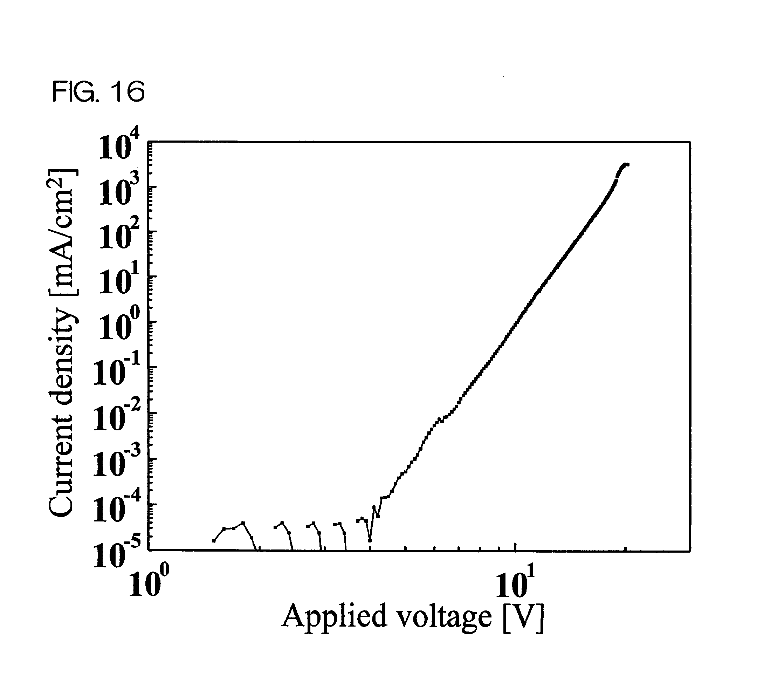

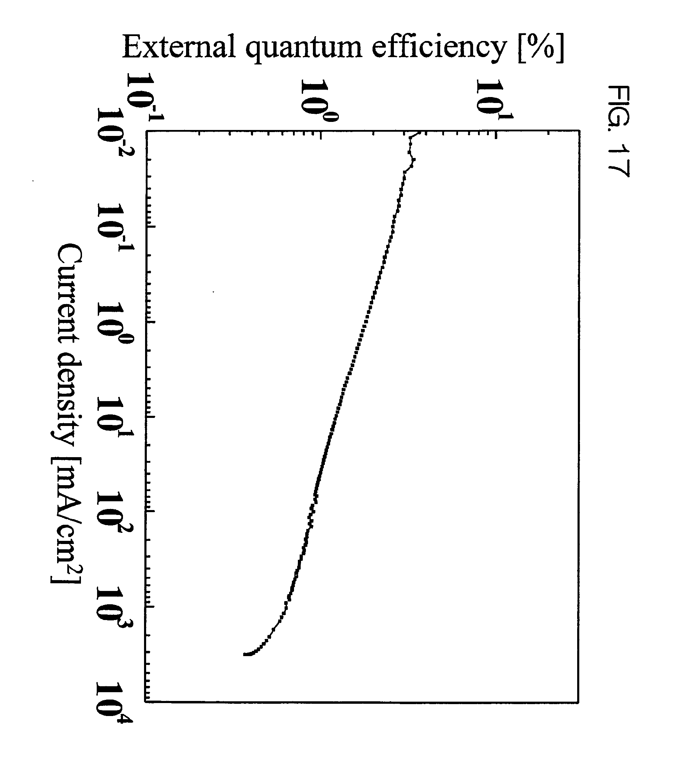

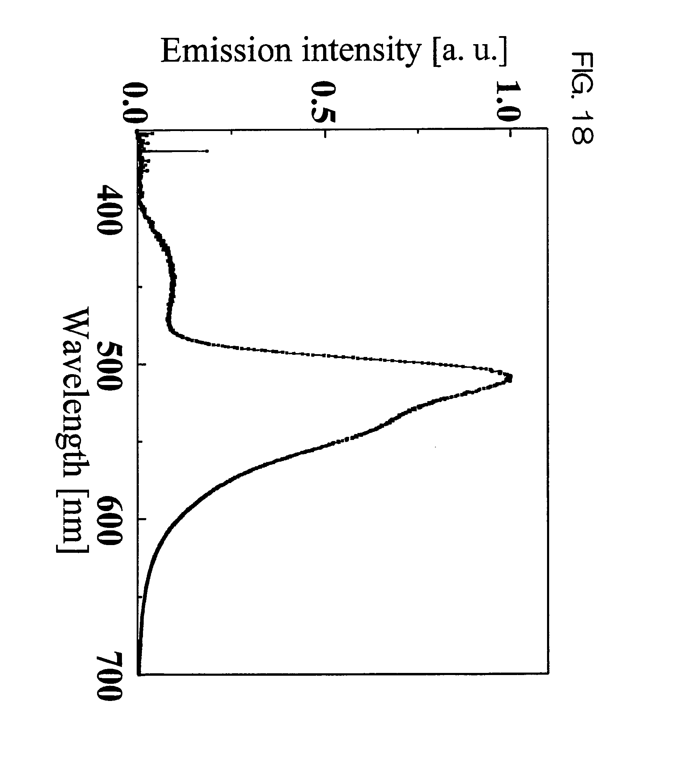

A cathode and an anode of the organic EL device were connected to a DC power supply and DC voltage was applied to an electroluminescent layer in an atmospheric air at room temperature (23±1°C) to emit light. As a result, the results shown in Figs. 16 to 18 were obtained. Fig. 16 is a graph showing a relation between the applied voltage and the current density, Fig. 17 is a graph showing a relation between the current density and the external quantum efficiency, and Fig. 18 is a graph showing the results of the measurement of the emission spectrum of the device, respectively. As is apparent from these drawings, the results confirmed that, according to the constitution of Example 5, it is possible to make an organic EL device to emit green light with high luminescent efficiency, that is, external quantum efficiency close to 10%.

### <Example 6>

The following respective layers were sequentially formed on a glass substrate by a vacuum deposition method to produce an organic EL device comprising an electroluminescent layer including a multilayered structure of four layers. A doping amount (content ratio) of a luminescent material doped in a luminescent layer was adjusted to 10% by weight based on the total amount of 3G1-pyridine represented by the formula (11-1) and a luminescent material.
Anode: 110 nm thick ITO layer
Hole transporting layer: 40 nm thick α-NPD layer represented by the formula (53)
Electron inhibiting layer: 10 nm thick mCP layer represented by the formula (56)
Luminescent layer: 20 nm thick layer formed by doping a layer made of 3G1-pyridine represented by the formula (11-1) as a host material with FIrpic represented by the formula (21) as a guest material (luminescent material)
Electron transporting layer: 40 nm thick Bphen layer represented by the formula (43)
Cathode: 100 nm thick magnesium-silver alloy layer
Protective layer: 10 nm thick silver layer

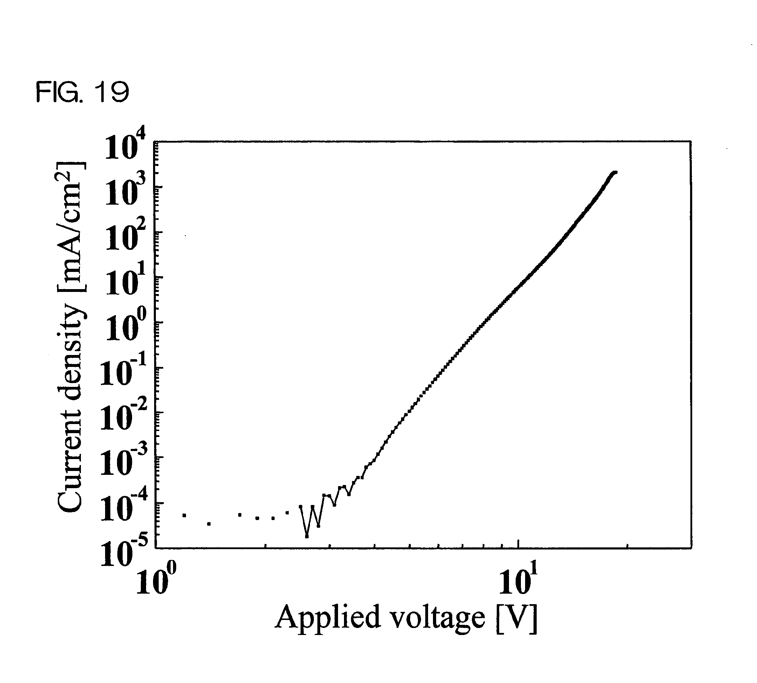

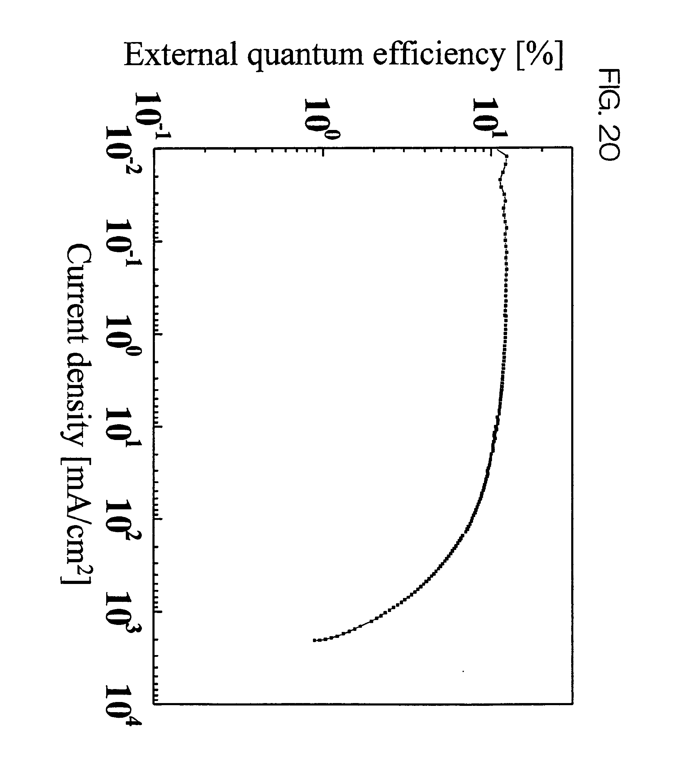

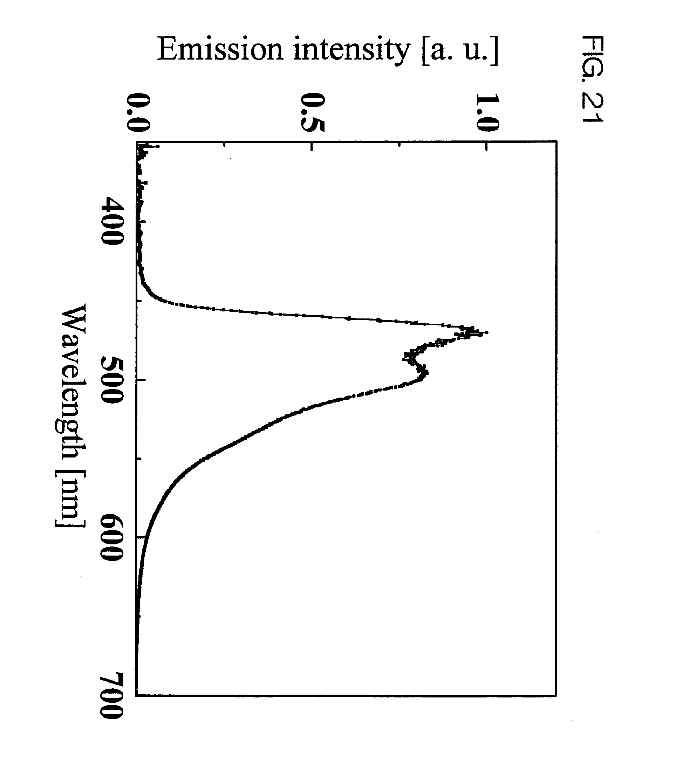

A cathode and an anode of the organic EL device were connected to a DC power supply and DC voltage was applied to an electroluminescent layer in an atmospheric air at room temperature (23±1°C) to emit light. As a result, the results shown in Figs. 19 to 21 were obtained. Fig. 19 is a graph showing a relation between the applied voltage and the current density, Fig. 20 is a graph showing a relation between the current density and the external quantum efficiency, and Fig. 21 is a graph showing the results of the measurement of the emission spectrum of the device, respectively. As is apparent from these drawings, the results confirmed that, according to the constitution of Example 6, it is possible to make an organic EL device to emit blue light with high luminescent efficiency, that is, external quantum efficiency of 10% or more.

### <Example 7>

The following respective layers were sequentially formed on a glass substrate by a vacuum deposition method to produce an organic EL device comprising an electroluminescent layer including a multilayered structure of five layers. A doping amount (content ratio) of a luminescent material in a luminescent layer was adjusted to 10% by weight based on the total amount of 3G1-pyridine represented by the formula (11-1) and a luminescent material.
Anode: 110 nm thick ITO layer
Hole transporting layer: 40 nm thick α-NPD layer represented by the formula (53)
Electron inhibiting layer: 10 nm thick mCP layer represented by the formula (56)
Luminescent layer: 20 nm thick layer formed by doping a layer made of 3G1-pyridine represented by the formula (11-1) as a host material with FIrpic represented by the formula (21) as a guest material (luminescent material)
Hole inhibiting layer: 10 nm thick 3G1-pyridine layer represented by the formula (11-1)
Electron transporting layer: 30 nm thick Alq₃ layer represented by the formula (29)
Cathode: 100 nm thick magnesium-silver alloy layer
Protective layer: 10 nm thick silver layer

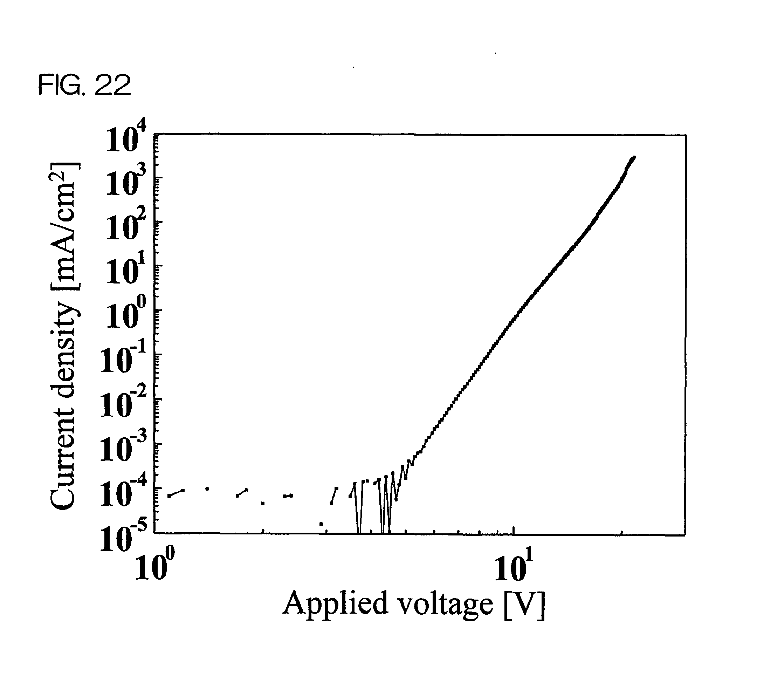

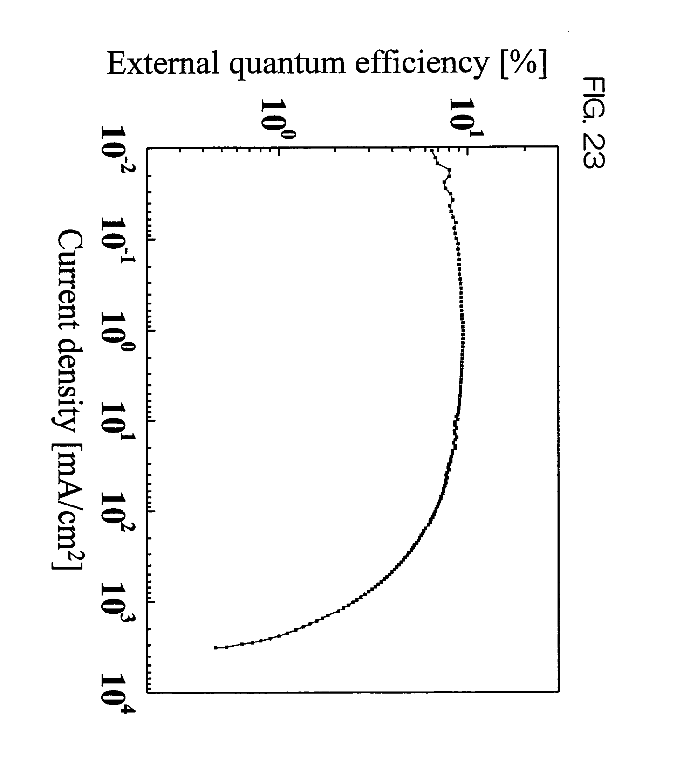

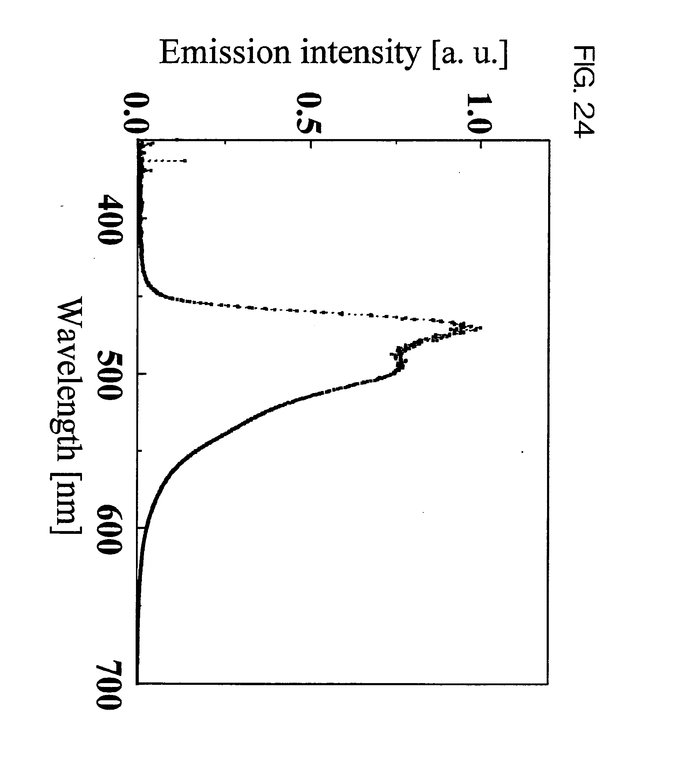

A cathode and an anode of the organic EL device were connected to a DC power supply and DC voltage was applied to an electroluminescent layer in an atmospheric air at room temperature (23±1°C) to emit light. As a result, the results shown in Figs. 22 to 24 were obtained. Fig. 22 is a graph showing a relation between the applied voltage and the current density, Fig. 23 is a graph showing a relation between the current density and the external quantum efficiency, and Fig. 24 is a graph showing the results of the measurement of the emission spectrum of the device, respectively. As is apparent from these drawings, the results confirmed that, according to the constitution of Example 7, it is possible to make an organic EL device to emit blue light with high luminescent efficiency, that is, external quantum efficiency close to 10%.

### <Comparative Example 1>

The following respective layers were sequentially formed on a glass substrate by a vacuum deposition method to produce an organic EL device comprising an electroluminescent layer including a multilayered structure of four layers. A doping amount (content ratio) of a luminescent material in a luminescent layer was adjusted to 6% by weight based on the total amount of CBP represented by the formula (51) and a luminescent material.
Anode: 110 nm thick ITO layer
Hole injecting layer: 10 nm thick CuPC layer represented by the formula (55)
Hole transporting layer: 30 nm thick α-NPD layer represented by the formula (53)
Luminescent layer: 30 nm thick layer formed by doping a layer made of CBP represented by the formula (51) as a host material with FIrpic represented by the formula (21) as a guest material (luminescent material)
Electron transporting layer: 30 nm thick BAlq₃ layer represented by the formula (45)
Cathode: 100 nm layer made of lithium fluoride
Cathode: 100 nm thick aluminum layer

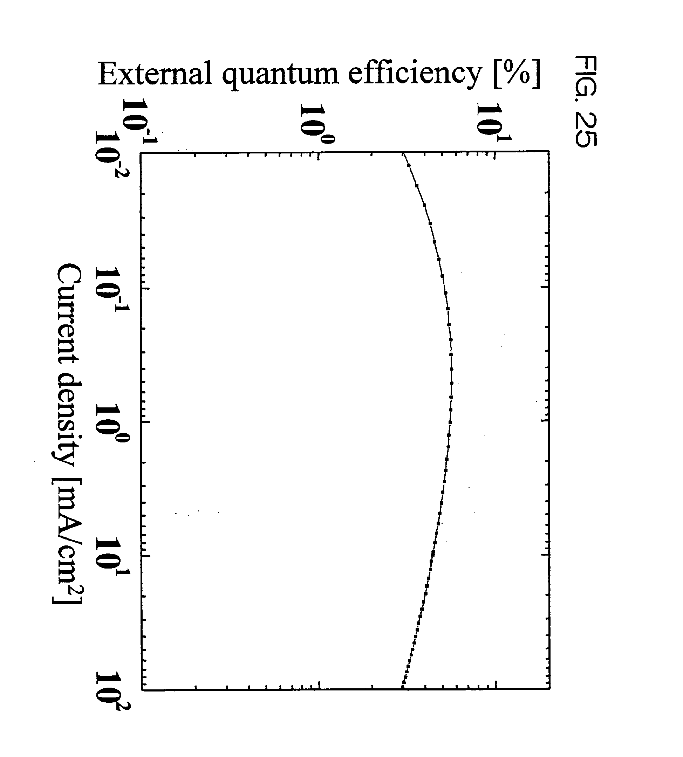

A cathode and an anode of the organic EL device were connected to a DC power supply and DC voltage was applied to an electroluminescent layer in an atmospheric air at room temperature (23±1°C) to emit light. As a result, the results shown in Fig. 25 were obtained. Fig. 25 is a graph showing a relation between the current density and the external quantum efficiency. As is apparent from the drawing, the results confirmed that, according to the constitution of Comparative Example 1, it is possible to make an organic EL device to emit light only with low luminescent efficiency, that is, external quantum efficiency of about 5.7%.

## Claims

1. An organic electroluminescent device comprising an electroluminescent layer having a single layer or a multilayered structure of two or more layers, a cathode for injecting electrons into the electroluminescent layer, and an anode for injecting holes into the electroluminescent layer, wherein the electroluminescent layer contains a pyridine derivative represented by the formula (1): 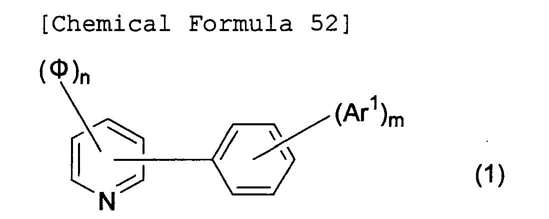 wherein Ar¹ represents an aryl group which may have a substituent; m represents an integer of 1 to 5 and, when m is an integer of 2 or more, each Ar¹ may be the same or different; Φ represents a group represented by the formula (1a): 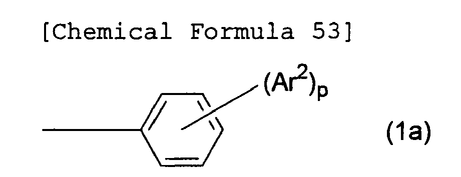 (wherein Ar² represents an aryl group which may have a substituent, p represents an integer of 1 to 5 and, when p is an integer of 2 or more, each Ar² may be the same or different), or
the formula (1b) : 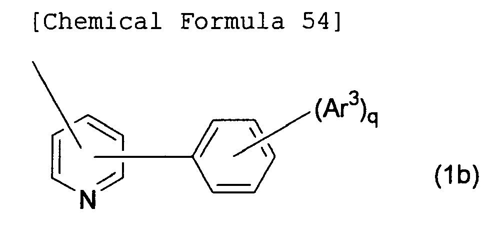 (wherein Ar³ represents an aryl group which may have a substituent, q represents an integer of 1 to 5 and, when q is an integer of 2 or more, each Ar³ may be the same or different); and n represents an integer of 0 to 2 and, when n is 2, each Φ may be the same or different.

2. The organic electroluminescent device according to claim 1, wherein the pyridine derivative is a compound in which Ar¹ is a phenyl group, m is 4, and n is 0 in the formula (1).

3. The organic electroluminescent device according to claim 2, wherein the pyridine derivative is at least one selected from the group consisting of a compound represented by the formula (11-1): 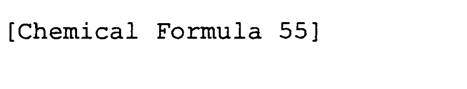 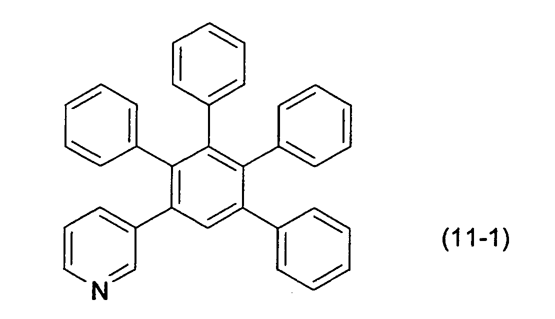 and a compound represented by the formula (11-2):

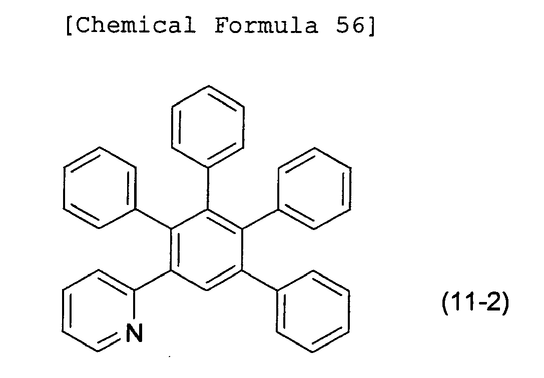

4. The organic electroluminescent device according to claim 1, wherein the pyridine derivative is a compound in which Ar¹ is a phenyl group, m is 4, n is 1 and Φ is a group represented by the formula (1a) in the formula (1), and Ar² is a phenyl group and p is 4 in the formula (1a).

5. The organic electroluminescent device according to claim 4, wherein the pyridine derivative is at least one selected from the group consisting of a compound represented by the formula (12-1): 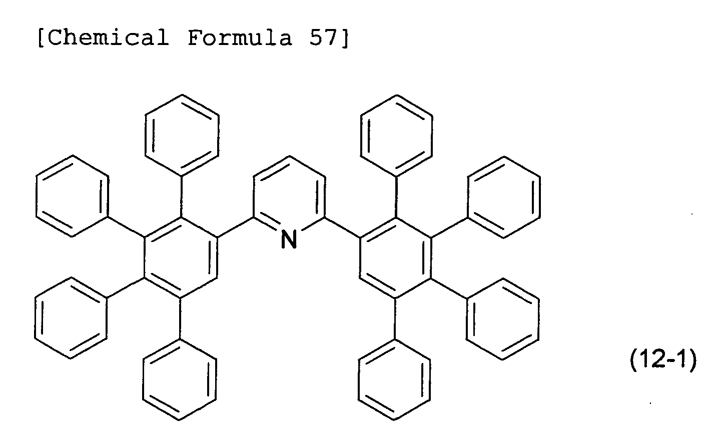 and a compound represented by the formula (12-2):

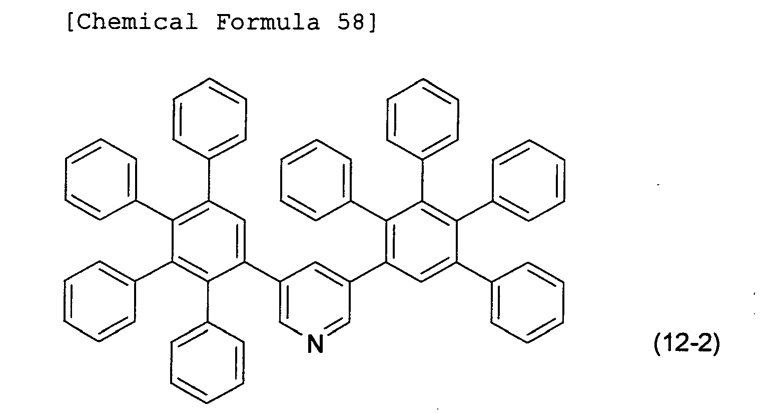

6. The organic electroluminescent device according to claim 1, wherein the pyridine derivative is a compound in which Ar¹ is a phenyl group, m is 4, n is 1 and Φ is a group represented by the formula (1b) in the formula (1), and Ar³ is a phenyl group and q is 4 in the formula (1b).

7. The organic electroluminescent device according to claim 6, wherein the pyridine derivative is a compound represented by the formula (13-1):

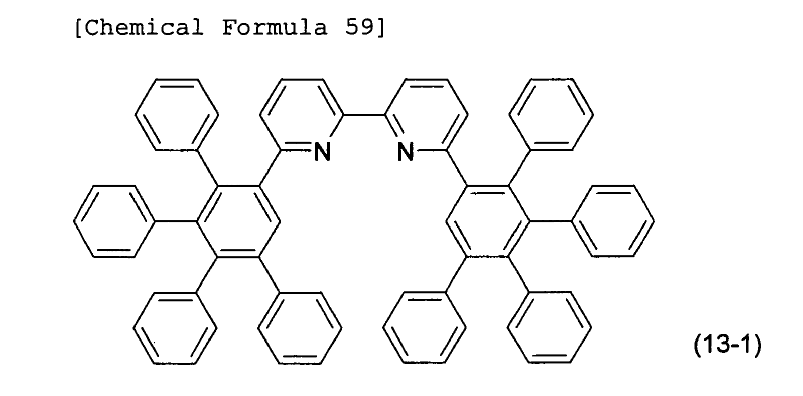

8. The organic electroluminescent device according to claim 1, wherein the pyridine derivative is a compound in which Ar¹ is a phenyl group, m is 4 and n is 0 in the formula (1), and two Ar¹ among four Ar¹ are substituted with each one group represented by the formula (1c): 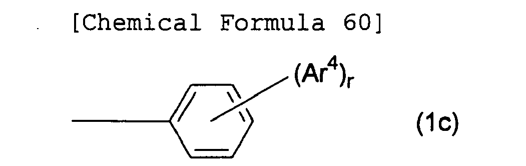 (wherein Ar⁴ represents an aryl group which may have a substituent, r represents an integer of 1 to 5 and, when r is an integer of 2 or more, each Ar⁴ may be the same or different), in which Ar⁴ is a phenyl group or a tolyl group, and r is 4 in the formula.

9. The organic electroluminescent device according to claim 8, wherein the pyridine derivative is at least one selected from the group consisting of a compound represented by the formula (14-1): 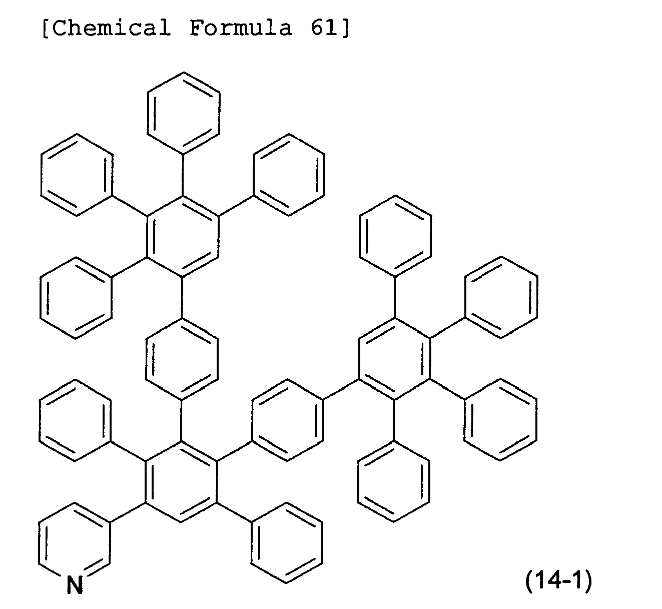 and a compound represented by the formula (14-2):

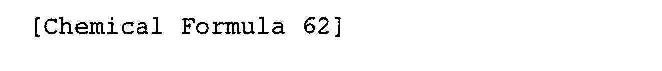

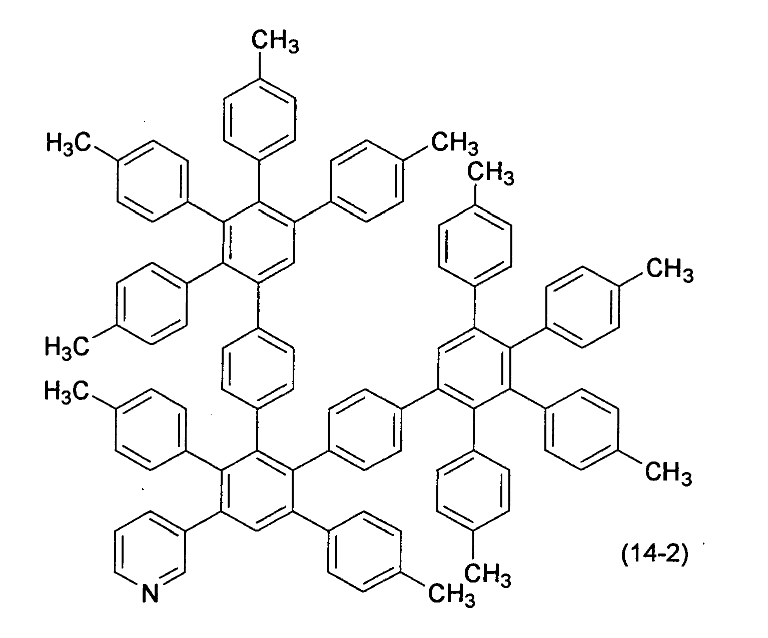

10. The organic electroluminescent device according to claim 1, wherein the electroluminescent layer has a multilayered structure of two or more layer which contains a luminescent layer containing a luminescent material as a guest material and a pyridine derivative represented by the formula (1) as a host material.

11. The organic electroluminescent device according to claim 10, which comprises, as the other layer constituting an electroluminescent layer having a multilayered structure together with the luminescent layer, at least one of an electron transporting layer formed between the luminescent layer and the cathode, and a hole transporting layer formed between the luminescent layer and the anode.

12. The organic electroluminescent device according to claim 1, wherein the electroluminescent layer is a luminescent layer having a single layer which contains a luminescent material as a guest material and a pyridine derivative represented by the formula (1) as a host material.

13. The organic electroluminescent device according to claim 1, wherein the electroluminescent layer has a multilayered structure of two or more layers which contains an electron transporting layer containing a pyridine derivative represented by the formula (1) as an electron transporting material.

14. The organic electroluminescent device according to claim 13, which comprises, as the other layer constituting an electroluminescent layer having a multilayered structure together with the electron transporting layer, a luminescent layer formed between the electron transporting layer and the anode and a hole transporting layer formed between the luminescent layer and the anode.

15. The organic electroluminescent device according to claim 13, which comprises, as the other layer constituting an electroluminescent layer having a multilayered structure together with the electron transporting layer, a hole transporting layer formed between the electron transporting layer and the anode, and either of the hole transporting layer and the electron transporting layer also serves as the luminescent layer.
